(19) Europäisches Patentamt / European Patent Office / Office européen des brevets

(11) **EP 4 772 673 A1**

(12) **EUROPEAN PATENT APPLICATION**
published in accordance with Art. 153(4) EPC

(43) Date of publication:
08.07.2026 Bulletin 2026/28

(21) Application number: 24859518.3

(22) Date of filing: 19.08.2024

(51) International Patent Classification (IPC):
$C23F\ 13/10$ (2006.01)    $C22C\ 18/04$ (2006.01)
$C23C\ 2/06$ (2006.01)    $C23F\ 13/02$ (2006.01)
$C23C\ 2/26$ (2006.01)

(52) Cooperative Patent Classification (CPC):
C22C 18/04; C23C 2/06; C23F 13/02; C23F 13/10;
C23C 2/26

(86) International application number:
PCT/JP2024/029297

(87) International publication number:
WO 2025/047485 (06.03.2025 Gazette 2025/10)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 31.08.2023 JP 2023141472

(71) Applicant: Nippon Steel Corporation
Tokyo 100-8071 (JP)

(72) Inventors:
• SHIMIZU, Atsuo
Tokyo 100-8071 (JP)
• SHOJI, Hiromasa
Tokyo 100-8071 (JP)

(74) Representative: Vossius & Partner
Patentanwälte Rechtsanwälte mbB
Siebertstraße 3
81675 München (DE)

(54) **SURFACE-TREATED MEMBER**

(57) [PROBLEM] There is provided a surface-treated member that exhibits excellent corrosion resistance even in the soil at a depth of about several centimeters from the soil surface.

[SOLUTION] The surface-treated member of the present invention is formed of a surface-treated steel material including: a steel material serving as a base material; and zinc-based coatings layers, a steel base exposed portion is present in at least a portion of the zinc-based coatings layer, in a case where a cross section obtained by cutting the steel base exposed portion in the thickness direction of the steel material according to the shape of the steel base exposed portion when the zinc-based coatings layer is viewed in plan from above is observed with a microscope, at least one or more cross sections each having a steel base exposure ratio falling within a range of 1.0 to 40.0% are present, in the cross section having the steel base exposure ratio falling within a range of 1.0 to 40.0%, the shortest distance from any point on the surface of the exposed steel material to the zinc-based coatings layer is greater than 0 μm and 50.0 μm or less, and the total area of regions where a cross section having the steel base exposure ratio being greater than 40.0% is given is 5.0% or less relative to the entire area of the steel base exposed portion.

FIG. 6

**Description**

TECHNICAL FIELD

The present invention relates to a surface-treated member.

BACKGROUND ART

A zinc-based coated steel material, in which various zinc-based coatings layers as a surface-treated layer are provided on surfaces of a steel material serving as a base material, is a raw material that has been widely used in fields such as construction and automobiles from the viewpoint of improving corrosion resistance of structural members. The zinc-based coated steel material as the raw material is worked into various shapes, and then they are joined to each other by joining treatments using fastening members such as screws, bolts, and rivets, various welding methods, and the like as necessary, and thereby a surface-treated member having a desired shape is formed.

Such a surface-treated member as described above is considered to be exposed to various corrosive environments depending on the application of such a surface-treated member. Therefore, various studies have been conventionally conducted on the corrosion resistance of a surface-treated steel material serving as a raw material.

For example, Patent Document 1 below has proposed a surface-treated steel including a coating film containing zinc or an alloy mainly composed of zinc and a predetermined amount of at least either Mg or In, with the aim of achieving corrosion resistance excellent in various corrosive environments such as an alkaline corrosion environment, a seawater corrosion environment, a tap-water corrosion environment, a high temperature/humidity corrosion environment, a soil corrosion environment, and an atmospheric corrosion environment. In Patent Document 1 as above, corrosion resistance in various corrosive environments has been studied using an excellent sacrificial anticorrosive effect of zinc.

PRIOR ART DOCUMENT

PATENT DOCUMENT

Patent Document 1: Japanese Laid-open Patent Publication No. H11-158657

SUMMARY OF THE INVENTION

PROBLEMS TO BE SOLVED BY THE INVENTION

When installing the surface-treated member at a desired place, it is presumed that at least a portion of the member is often buried in the soil. If the surface-treated member has a portion exposed to the atmosphere, the corrosion condition can be easily investigated by visually observing the exposed portion. However, it is difficult for the portion buried in the soil, unlike in the atmosphere, to visually investigate the corrosion condition, and maintenance of the portion in a corrosion state is also difficult. Thus, the surface-treated member to be used in the soil is required to have high corrosion resistance.

The present inventors studied corrosion conditions of the zinc-based coated steel material in the soil. As a result, as will be described later, they found out that the corrosion behavior of the zinc-based coated steel material in the soil at a depth of 1 m or more from the soil surface is significantly different from the corrosion behavior of the zinc-based coated steel material in the soil at a depth of about several centimeters from the soil surface, and further that the soil corrosion environment that draws attention in Patent Document 1 described above mainly corresponds to the corrosion behavior in the soil at a depth of 1 m or more from the soil surface. Furthermore, they found out that even if a surface-treated member is manufactured using such a surface-treated steel as disclosed in Patent Document 1 described above as a raw material, there is room for improvement in the corrosion resistance in such soil at a depth of about several centimeters from the soil surface.

Thus, the present invention has been made in consideration of the above problem, and an object of the present invention is to provide a surface-treated member using a zinc-based coated steel material capable of exhibiting excellent corrosion resistance even in the soil at a depth of about several centimeters from the soil surface.

MEANS FOR SOLVING THE PROBLEMS

In order to solve the above-described problem, the present inventors conducted extensive studies and then came up with an idea of changing the state of a zinc-based coatings layer to be provided as a surface-treated layer according to the corrosive environment to which the surface-treated member is exposed. As a result that the present inventors conducted further studies based on such an idea, they conceived such a surface-treated member as will be explained below.

The gist of the present invention completed based on such an idea is as follows.

(1) A surface-treated member being a surface-treated member formed of a surface-treated steel material including: a steel material serving as a base material; and zinc-based coatings layers located on surfaces of the steel material, in which a steel base exposed portion, which is a portion where the surface of the steel material is exposed, is present in at least a portion of the zinc-based coatings layer, in a case where a cross section obtained by cutting the steel base exposed portion in the thickness direction of the steel material according to the shape of the steel base exposed portion when the zinc-based coatings layer is viewed in plan from above is observed with a microscope, at least one or more cross sections each having a steel base exposure ratio, which is a ratio of a portion where the surface of the steel material is exposed in the cross section, falling within a range of 1.0 to 40.0% are present, in the cross section having the steel base exposure ratio falling within a range of 1.0 to 40.0%, the shortest distance from any point on the surface of the exposed steel material to the zinc-based coatings layer is greater than 0 $\mu$m and 50.0 $\mu$m or less, and for each of regions where a cross section having the steel base exposure ratio being greater than 40.0% is given, the total area of the regions when viewed in plan from above is 5.0% or less relative to the entire area of the steel base exposed portion.

(2) The surface-treated member according to (1), used by burying at least a portion of the steel base exposed portion in soil.

(3) The surface-treated member according to (2), in which the steel base exposed portion is specified by performing a color identification test, which causes a color reaction at a portion where a steel base is exposed, over the entire surface of the zinc-based coatings layer, in a case where each of the specified steel base exposed portions is viewed in plan from above the zinc-based coatings layer, each of the steel base exposed portions is virtually divided into rectangular regions each having a short side of 5 mm or more and an area of 1 cm$^2$ as a division, and for each of the divisions where the area ratio of the steel base exposed portion to the rectangular region is 3% or more, the cross section of each of the divisions is observed, and thereby the steel base exposure ratio is measured, and the ratio of the total area of the divisions where the cross section having the steel base exposure ratio falling within a range of 1.0 to 40.0% is obtained to the area of a portion buried in the soil is 5.0% or more.

(4) The surface-treated member according to any one of (1) to (3), in which the zinc-based coatings layer is a coatings layer having a chemical composition containing, in mass%, Al: 0.10% or more and less than 40.00%, and Mg: 0.10% or more and less than 15.00%, with the balance consisting of Zn and impurities.

(5) The surface-treated member according to (4), in which the zinc-based coatings layer is a coatings layer containing, in mass%, Al: 0.10% or more and less than 40.00%, Mg: 0.10% or more and less than 15.00%, and Zn: 60.00% or more.

(6) The surface-treated member according to any one of (1) to (3), in which the zinc-based coatings layer is a coatings layer having a chemical composition containing, in mass%, Al: 0.10% or more and less than 40.00%, Mg: 0.10% or more and less than 15.00%, and further containing one or two or more selected from the group consisting of an element group A, an element group B, an element group C, an element group D, an element group E, and an element group F described below, with the balance consisting of Zn and impurities.

[Element group A]: one or two selected from the group consisting of Si: 2.50% or less and Fe: 5.00% or less
[Element group B]: one or two or more selected from the group consisting of Sb: less than 0.50%, Pb: less than 0.50%, and Sr: less than 0.50%
[Element group C]: one or two or more selected from the group consisting of Cu: less than 0.25%, Ti: less than 0.25%, Cr: less than 0.25%, Nb: less than 0.25%, Ni: less than 0.25%, Mn: less than 0.25%, Co: less than 0.25%, and V: less than 0.25%
[Element group D]: one or two or more selected from the group consisting of Sn: 20.00% or less, Bi: less than 5.00%, and In: less than 2.00%
[Element group E]: one or two or more selected from the group consisting of Ca: 3.00% or less, La: less than 0.50%, Ce: less than 0.50%, and Y: 0.50% or less
[Element group F]: B: less than 0.50%

(7) The surface-treated member according to (6), in which the chemical composition contains the element group A.
(8) The surface-treated member according to (6), in which the chemical composition contains the element group B.
(9) The surface-treated member according to (6), in which the chemical composition contains the element group C.
(10) The surface-treated member according to (6), in which the chemical composition contains the element group D.
(11) The surface-treated member according to (6), in which the chemical composition contains the element group E.
(12) The surface-treated member according to (6), in which the chemical composition contains the element group F.

(13) The surface-treated member according to (6), in which the zinc-based coatings layer is a coatings layer containing at least, in mass%, Al: 4.0% or more and less than 25.0%, and Mg: 0.3% or more and less than 12.5%.

(14) The surface-treated member according to any one of (1) to (3), in which when the upper limit of measured values of the steel base exposure ratio obtained is denoted as A [%] and the coating weight per side of the zinc-based coatings layer is denoted as B [g/m$^2$], Formula (1) and Formula (2) below are both satisfied.

$$A \leq 0.8 \times 10^{-1} \times B + 28.0 \ ... \ \text{Formula (1)}$$

$$A \leq 40.0 \ ... \ \text{Formula (2)}$$

(15) The surface-treated member according to any one of (1) to (3), in which the coating weight of the zinc-based coatings layer is 50.0 to 150.0 g/m$^2$ per side.

(16) The surface-treated member according to (14), in which the coating weight of the zinc-based coatings layer is 50.0 to 150.0 g/m$^2$ per side.

(17) The surface-treated member according to any one of (1) to (3), in which at least one or more cross sections each having the steel base exposure ratio falling within a range of 5.0 to 40.0% are present.

EFFECT OF THE INVENTION

As explained above, according to the present invention, it becomes possible to exhibit excellent corrosion resistance even in the soil at a depth of about several centimeters from the soil surface.

BRIEF DESCRIPTION OF THE DRAWINGS

FIG. 1 is a schematic view for explaining a structure installed in a soil surface.

FIG. 2 is a schematic view for explaining a structure of a surface-treated member according to an embodiment of the present invention.

FIG. 3 is a schematic view for explaining the structure of the surface-treated member according to the embodiment.

FIG. 4 is a schematic view for explaining the structure of the surface-treated member according to the embodiment.

FIG. 5 is an explanatory view for explaining a steel base exposure ratio in the surface-treated member according to the embodiment.

FIG. 6 is an explanatory view for explaining the steel base exposure ratio in the surface-treated member according to the embodiment.

FIG. 7 is an explanatory view for explaining the steel base exposure ratio in the surface-treated member according to the embodiment.

FIG. 8 is an explanatory view for explaining a modified example of the steel base exposure ratio in the surface-treated member according to the embodiment.

EMBODIMENTS FOR CARRYING OUT INVENTION

A preferred embodiment of the present invention will be explained in detail with reference to the accompanying drawings below. Incidentally, in this description and the drawings, components having substantially the same functional configurations are denoted by the same reference numerals and symbols, and thereby their redundant explanations are omitted.

(Corrosion behavior in the soil at a depth of about several centimeters from a soil surface)

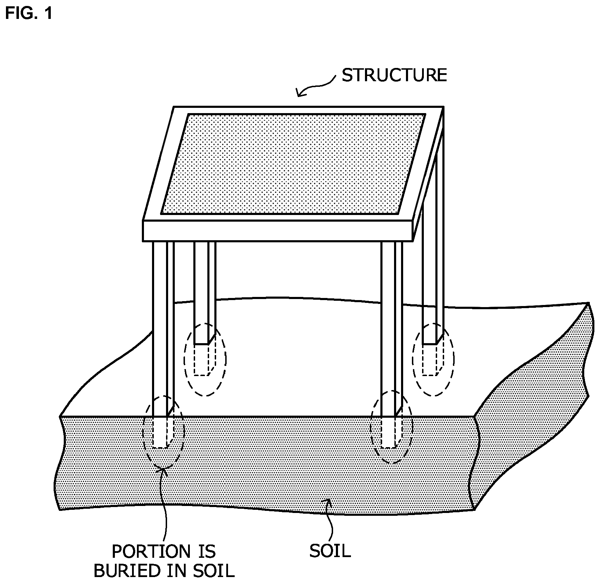

Before explaining the surface-treated member according to the embodiment of the present invention, the corrosion behavior in the soil at a depth of about several centimeters from the soil surface, which has been discovered by the present inventors, will be explained with reference to FIG. 1. FIG. 1 is a schematic view for explaining a structure installed in the soil surface. Further, in the following, the "soil at a depth of about several centimeters from the soil surface" is sometimes referred to as a "soil surface portion" as a matter of convenience.

As schematically illustrated in FIG. 1, for example, various structures such as a stand on which a solar power generation panel is placed, a road sign, a guardrail, and a traffic light are installed in the soil surface. At this time, in order to install the structure in the soil surface more stably, a portion of the structure (for example, each portion surrounded by the dashed line in FIG. 1, such as the vicinity of a lower end portion of each support post) is often buried in the soil as illustrated in FIG. 1.

Here, for the various structures, various steel materials are often used as a raw material, for example, from the viewpoint of production costs. Here, when a portion of the structure using various steel materials as a raw material is buried in the soil, there is a concern about corrosion of the steel materials being the raw material.

As the effect of soil on the corrosion of steel materials, there can be cited two effects: retention of moisture, which is a corrosion factor, and inhibition of oxygen diffusion, which is also a corrosion factor. The retention of moisture has an effect to work in the direction in which it increases a corrosion rate, while the inhibition of oxygen diffusion has an effect to work in the direction in which it reduces the corrosion rate. In the soil, a wet environment (namely, moisture) is maintained for a longer time after rainfall or the like, compared to that in the atmosphere. On the other hand, the corrosion rate decreases because the permeation and diffusion of oxygen from the atmosphere are inhibited by the soil. The corrosion rate in the actual soil is fixed to a certain level as a result of the interaction of the two effects that are in a trade-off relationship as described above. In general, the effect of inhibition of oxygen diffusion is greater than that of retention of moisture, and thus the corrosion rate is suppressed in the soil compared to that in the atmosphere.

On the other hand, the condition is significantly different in the soil at a depth of about several centimeters from the soil surface (soil surface portion). Even in the soil surface portion, moisture is less likely to evaporate due to the soil, to thus make the steel material remain in contact with moisture for a longer time compared to that in the atmosphere. In the soil surface portion, on the other hand, due to the distance from the atmosphere being short, oxygen is supplied from the atmosphere quickly, and thus the effect of inhibition of oxygen diffusion by the soil is small. Therefore, it is thought that the corrosion inhibition effect by the soil is hardly obtained in the soil surface portion, combined with the effect of retention of moisture. Thus, the soil surface portion that the present inventors focused on can be said to be in an extremely severe corrosive environment compared to in the soil at a depth of 1 m or more from the soil surface.

In order to study the corrosion behavior of the steel material in the soil surface portion, the present inventors studied the corrosion behavior of the zinc-based coated steel material in the soil surface portion and then found out the following.

That is, the zinc-based coatings layer included in the zinc-based coated steel material exhibits high corrosion resistance in the atmosphere by covering the surface of the coatings layer with zinc-based corrosion products. In the soil surface portion, however, it became clear that an anticorrosive function provided by such zinc-based corrosion products is low.

The present inventors observed the zinc-based corrosion product produced on the zinc-based coatings layer in the soil surface portion using a scanning electron microscope (SEM) or the like. As a result, it became clear that the zinc-based corrosion product produced in the soil surface portion is in a porous state compared to the zinc-based corrosion product produced in the atmosphere. This was thought to be because corrosion progresses more rapidly in the soil surface portion than in the atmosphere.

From such findings as described above, the present inventors were able to learn that in order to improve corrosion resistance of the zinc-based coated steel material in the soil surface portion, it is important to change the corrosion product formed on the zinc-based coatings layer in the soil surface portion into a product produced in a dense state.

In order to achieve the corrosion product that is produced in a dense state in the soil surface portion, the present inventors conducted further studies and then came up with an idea of intentionally providing a portion where the surface of the steel material is exposed (hereinafter referred to as a "steel base exposed portion") at a specific abundance ratio in a portion of the zinc-based coatings layer, which is different from the conventional technical idea. They found out that this makes it possible to produce a corrosion product in a dense state on the surface of the zinc-based coatings layer even in the soil surface portion.

In the conventional technical idea, the zinc-based coatings layer was provided to be in a dense state so as to prevent the steel base from being exposed as much as possible, and then protected the steel base by utilizing the sacrificial anticorrosive effect that zinc exhibits. However, the present inventors found out that a portion where the steel base is exposed is intentionally provided in the zinc-based coatings layer, thereby making it possible to produce a corrosion product in a dense state different from that in the atmosphere, starting from such an exposed portion. The steel base and the zinc-based coatings layer in the vicinity thereof are protected by such a corrosion product.

When the steel base exposed portion is located in the soil, the zinc-based coatings layer and the steel base are both exposed to corrosion factors in the soil (namely, moisture and oxygen). This causes Zn ions to be dissolved from the zinc-based coatings layer and causes Fe ions to be dissolved from the steel base. In the atmosphere, the dissolved Zn ions and Fe ions are washed away by rain, or the like, and are unlikely to adhere to the exposed portion. On the other hand, there is no water flow in the soil, and thus it is presumed that the dissolved Zn and Fe ions are likely to adhere to the steel base exposed portion and Fe-Zn-based composite oxides in a dense state are produced as corrosion products on the steel base exposed portion.

Further, as a result of study by the present inventors, it became clear that when the zinc-based coatings layer is an alloy plating layer containing Mg and Al in addition to Zn, in addition to Zn ions, Mg ions and Al ions are dissolved in the soil. It became clear that Fe-Zn-Al-Mg-based composite oxides are produced by such dissolution, and the corrosion resistance further improves.

The present inventors conducted further studies based on such findings as explained above, and as a result, they conceived such a surface-treated member according to the embodiment of the present invention, as will be described in detail below.

(Regarding the surface-treated member)

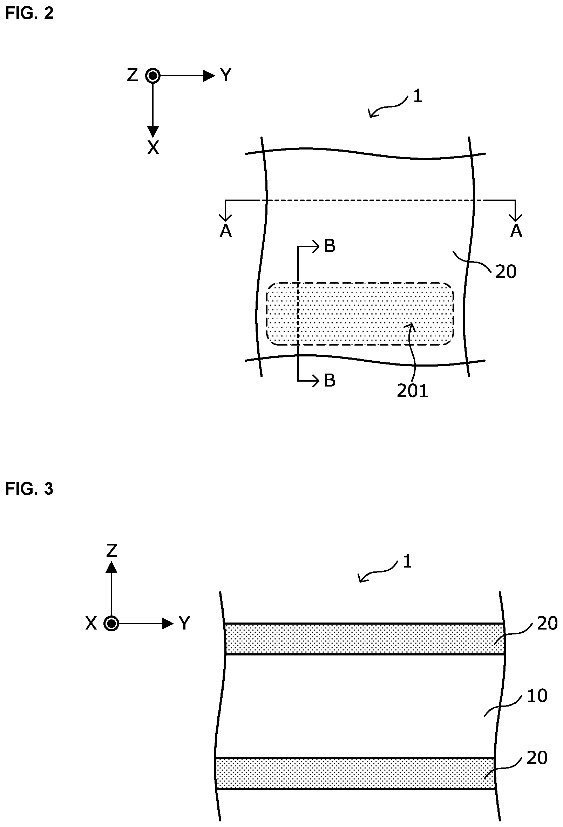

The surface-treated member according to the embodiment of the present invention will be explained in detail below with reference to FIG. 2 to FIG. 4. FIG. 2 to FIG. 4 each are a schematic view for explaining the structure of the surface-treated member according to this embodiment. Further, in FIG. 2 to FIG. 4, the explanation will be given using coordinate axes illustrated in the drawings for convenience.

The surface-treated member according to this embodiment is formed of a surface-treated steel material including a zinc-based coatings layer as a raw material, as will be described in detail below. Here, a specific structure of the surface-treated member according to this embodiment is not particularly limited. The specific structure of the surface-treated member according to this embodiment may be, for example, a box-shaped structure, or a plate-shaped structure using a plate-shaped steel material, such as a roof or a wall of a building. Further, the specific structure of the surface-treated member according to this embodiment may be, for example, a formed body or a joined body using various types of shape steel, such as a solar power generation panel stand, or a formed body or a joined body using various types of H-shaped steel or square pillars, such as a framework of a structure, or a formed body or a joined body using various steel pipes, such as various support posts, signs, traffic lights, or guardrails.

FIG. 2 schematically illustrates a part of the surface-treated member according to this embodiment, when viewed from above its surface in plan view (in the Z-axis direction in the drawing). As schematically illustrated in FIG. 2, a surface-treated member 1 according to this embodiment is one using, as a raw material, a zinc-based coated steel sheet in which a zinc-based coatings layer 20 is provided on the surface of a steel sheet serving as a base material, and a steel base exposed portion 201, which is a portion where the surface of the steel material is exposed, is present in at least a portion of the surface (corresponding to an XY plane in FIG. 2, the surface of the zinc-based coatings layer 20).

Here, FIG. 2 schematically illustrates the whole of the steel base exposed portion 201 in a substantially rectangular shape. However, in the surface-treated member 1 according to this embodiment, a specific shape of the steel base exposed portion 201 is not limited to the shape illustrated in FIG. 2.

FIG. 3 illustrates a schematic cross section obtained by cutting the surface-treated member 1 illustrated in FIG. 2 in the Z-axis direction along the A-A cutting line. The cross-sectional view illustrated in FIG. 3 corresponds to one obtained by cutting a portion of the surface-treated member 1 according to this embodiment, where the steel base exposed portion 201 is not present, in the thickness direction of the zinc-based coated steel material serving as the raw material of the surface-treated member 1.

As schematically illustrated in FIG. 3, the portion of the surface-treated member 1 according to this embodiment other than the steel base exposed portion 201 is formed of a surface-treated steel material including a steel material 10 serving as the base material, and the zinc-based coatings layers 20 located on the surfaces of the steel material 10 (namely, the zinc-based coated steel material).

First, such a steel material 10 and a zinc-based coatings layer 20 will be explained in detail below.

<Regarding the steel material 10>

The steel material 10 used as the base material of the surface-treated member 1 according to this embodiment is not particularly limited, and various steel materials can be used according to the mechanical strength (for example, tensile strength) or the like required for the surface-treated member 1. Examples of such a steel material 10 include various types of Al-killed steel, ultra-low carbon steel containing Ti, Nb, and so on, high-strength steel in which ultra-low carbon steel further contains strengthening elements such as P, Si, and Mn, various other steel materials containing various components (Cr, N, Cu, B, Ni, Mg, Ca, V, Co, Zn, As, Y, Zr, Mo, Sn, Sb, Ta, W, Pb, Bi, REM, and so on), and so on.

Further, a pre-coatings layer may be provided on the steel material 10 before performing such zinc-based coatings as will be described later. Examples of metals that can be used for the pre-coatings layer include Ni, Sn, alloys of combined these elements, and so on. When using a pre-coated steel material that has been pre-coated with these coatings, it is possible to eliminate uncoatings (a place where coatings metals are repelled by an oxide film, or the like). This is presumably because, when the pre-coated steel material is immersed in a hot-dip coatings bath, metal elements in the hot-dip coatings bath react with the pre-coatings layer to form Ni(Sn)-Al-Fe-Zn. The coatings weight of the pre-coatings layer per side is preferably in a range of 0.2 to 2.0 $g/m^2$. The coatings weight of the pre-coatings layer is set to 0.2 $g/m^2$ or

more, thereby making it possible to securely exhibit an effect of inhibiting uncoatings obtained by such pre-coatings as described above. Further, the coatings weight of the pre-coatings layer is set to 2.0 g/m² or less, and thereby the dissolution of Fe is suppressed by the pre-coatings layer, and while preventing the Fe-Zn-based composite oxide from being less likely to be produced, such an effect of inhibiting uncoatings as described above can be achieved.

Further, the thickness of the steel material 10 is not particularly limited, and only needs to be set appropriately according to the mechanical strength required for the surface-treated member 1, or the like.

<Regarding the zinc-based coatings layer 20>

The zinc-based coatings layer 20 is formed over the entire surface of both surfaces of such a steel material 10 as described above. Such a zinc-based coatings layer 20 is not particularly limited as long as it contains at least zinc (Zn), and various well-known zinc-based coatings can be applied.

Examples of such zinc-based coatings include zinc coatings, typified by hot-dip galvanizing and alloyed hot-dip galvanizing, zinc-nickel coatings, zinc-iron coatings, zinc-chromium coatings, zinc-aluminum coatings, zinc-titanium coatings, zinc-magnesium coatings, zinc-manganese coatings, zinc-aluminum-magnesium coatings, zinc-aluminum-magnesium-silicon coatings, and so on. Further, as the zinc-based coatings, there may be used one containing, in the above-described coatings, cobalt, molybdenum, tungsten, nickel, titanium, chromium, aluminum, manganese, iron, magnesium, lead, bismuth, antimony, tin, copper, cadmium, arsenic, or the like, or one in which an inorganic substance such as silica, alumina, or titania is dispersed in the above-described coatings, as a small amount of dissimilar metal elements or impurities. The plating method is not particularly limited, and it is only necessary to use various well-known coatings methods such as an electroplating method, a hot-dip coatings method, a vapor deposition coatings method, a dispersion coatings method, a vacuum coatings method, and so on.

Among such various zinc-based coatings as described above, the zinc-based coatings layer 20 according to this embodiment is more preferably a zinc-based coatings layer having such chemical components as will be described in detail below, for example. As the zinc-based coatings layer 20, one having such chemical components as will be described in detail below is used, thereby making it possible to further improve various properties such as the corrosion resistance of the surface-treated member 1 according to this embodiment. First, such a more preferable chemical composition of the zinc-based coatings layer 20 as described above will be explained in detail below.

<<Regarding the chemical composition of the zinc-based coatings layer 20>>

The chemical composition of the zinc-based coatings layer 20 according to this embodiment has, according to one aspect, a chemical composition containing, in mass%, Al: 0.10% or more and less than 40.00% and Mg: 0.10% or more and less than 15.00%, with the balance consisting of Zn and impurities.

Further, in the chemical composition in one aspect of the zinc-based coatings layer 20 according to this embodiment, the zinc-based coatings layer 20 is more preferably a coatings layer containing, in mass%, Al: 0.10% or more and less than 40.00%, Mg: 0.10% or more and less than 15.00%, and Zn: 60.00% or more.

Further, the chemical composition of the zinc-based coatings layer 20 according to this embodiment has, according to another aspect, a chemical composition containing, in mass%, Al: 0.10% or more and less than 40.00% and Mg: 0.10% or more and less than 15.00%, and further containing one or two or more selected from the group consisting of an element group A, an element group B, an element group C, an element group D, an element group E, and an element group F described below, with the balance consisting of Zn and impurities.

[Element group A]: One or two selected from the group consisting of Si: 2.50% or less and Fe: 5.00% or less
[Element group B]: one or two or more selected from the group consisting of Sb: less than 0.50%, Pb: less than 0.50%, and Sr: less than 0.50%
[Element group C]: one or two or more selected from the group consisting of Cu: less than 0.25%, Ti: less than 0.25%, Cr: less than 0.25%, Nb: less than 0.25%, Ni: less than 0.25%, Mn: less than 0.25%, Co: less than 0.25%, and V: less than 0.25%
[Element group D]: one or two or more selected from the group consisting of Sn: 20.00% or less, Bi: less than 5.00%, and In: less than 2.00%
[Element group E]: one or two or more selected from the group consisting of Ca: 3.00% or less, La: less than 0.50%, Ce: less than 0.50%, and Y: 0.50% or less
[Element group F]: B: less than 0.50%

[Al: 0.10 mass% or more and less than 40.00 mass%]

Al is an element necessary for constituting the main metal structure (Zn-Al-Mg-based metal structure) in a preferred aspect of the zinc-based coatings layer 20 according to this embodiment. Therefore, a predetermined content or more of Al is preferably contained in order to ensure corrosion resistance as a coated steel material. When the content of Al in the zinc-based coatings layer 20 is less than 0.10 mass%, there is a possibility of failing to secure such corrosion resistance as described above. Therefore, in the zinc-based coatings layer 20 according to this embodiment, the content of Al is preferably 0.10 mass% or more. The content of Al is preferably 3.00 mass% or more, more preferably 4.00 mass% or more, and further preferably 6.00 mass% or more. The content of Al falls within such a range as described above, thereby making it possible to secure the corrosion resistance as the coated steel material.

On the other hand, when the content of Al in the zinc-based coatings layer 20 is 40.00 mass% or more, an Al phase, which functions as a cathode when placed in a corrosive environment, increases excessively and corrosion of the steel material 10 easily progresses, and thus there is a possibility of failing to secure the corrosion resistance as the coated steel material. Therefore, in the zinc-based coatings layer 20 according to this embodiment, the content of Al is preferably less than 40.00 mass%. The content of Al is preferably 25.00 mass% or less, more preferably less than 25.00 mass%, and further preferably 20.00 mass% or less.

[Mg: 0.10 mass% or more and less than 15.00 mass%]

Mg is an element necessary for constituting the main metal structure (Zn-Al-Mg-based metal structure) in the preferred aspect of the zinc-based coatings layer 20 according to this embodiment. Therefore, a predetermined content or more of Mg is preferably contained in order to ensure corrosion resistance as the coated steel material. When the content of Mg in the zinc-based coatings layer 20 is less than 0.10 mass%, there is a possibility of failing to secure such corrosion resistance as described above. Therefore, in the zinc-based coatings layer 20 according to this embodiment, the content of Mg is preferably 0.10 mass% or more. The content of Mg is preferably 0.30 mass% or more, and more preferably 3.00 mass% or more. The content of Mg falls within such a range as described above, thereby making it possible to secure the corrosion resistance as the coated steel material.

On the other hand, when the content of Mg in the zinc-based coatings layer 20 is 15.00 mass% or more, anodic dissolution of the zinc-based coatings layer easily progresses when placed in the corrosive environment, and thus there is a possibility of failing to secure corrosion resistance as the coated steel material. Therefore, in the zinc-based coatings layer 20 according to this embodiment, the content of Mg is preferably less than 15.00 mass%. The content of Mg is preferably less than 12.50 mass%, and more preferably 12.00 mass% or less. The content of Mg falls within such a range as described above, thereby making it possible to secure the corrosion resistance as the coated steel material.

In the zinc-based coatings layer 20 according to this embodiment, the balance other than Al and Mg described above is Zn and impurities.

Zn is an element necessary for constituting the main metal structure (Zn-Al-Mg-based metal structure) in the preferred aspect of the zinc-based coatings layer 20 according to this embodiment, and is an element important for improving the corrosion resistance as the coated steel material. Further, the zinc-based coatings layer 20 contains Al and Mg described above in the above-described ranges and further contains Zn, thereby making it possible to ensure the corrosion resistance required for the coated steel material.

Then, in the preferred aspect of the zinc-based coatings layer 20 according to another aspect of this embodiment, the element group A to the element group F that the chemical composition of such a zinc-based coatings layer 20 can have will be explained in detail.

Incidentally, in the zinc-based coatings layer 20 according to another aspect of this embodiment, when at least any of the elements belonging to the following element groups A to F is contained, it is preferable that at least any of the elements belonging to the following element groups A to F should be contained within the following content range to achieve a total content of 60.00 mass% or less.

The total content of the elements belonging to the element group A to the element group F is set to 60.00 mass% or less, thereby making it possible to enjoy such effects exhibited by adding each of the elements, as will be described in detail below, without mutual impairment. The total content of the elements belonging to the element group A to the element group F is preferably 50.00 mass% or less, and more preferably 40.00 mass% or less.

◇ Element group A

In another aspect of the zinc-based coatings layer 20 according to this embodiment, the element group A that the zinc-based coatings layer 20 can contain will be explained. At least any of the elements in the element group A described below is an element that can be contained in the zinc-based coatings layer 20 in place of part of Zn being the balance.

[Element group A]: one or two selected from the group consisting of Si: 2.50% or less and Fe: 5.00% or less

[Si: 0 mass% or more and 2.50 mass% or less]

In another aspect of the zinc-based coatings layer 20 according to this embodiment, the case of not containing Si can also be considered, and thus the lower limit of the content of Si is 0 mass%. On the other hand, Si is an element capable of inhibiting excessive growth of an Fe-Al-based metal structure formed at the interface between the zinc-based coatings layer 20 and the steel material 10 and further improving adhesiveness between the zinc-based coatings layer 20 and the steel material 10. When Si is contained in the zinc-based coatings layer 20, the content of Si is preferably 0.05 mass% or more, and more preferably 0.20 mass% or more for inhibiting excessive growth of the Fe-Al-based metal structure. On the other hand, when the content of Si exceeds 2.50 mass%, a high melting point intermetallic compound is excessively formed with Mg, which may inhibit the formation of Al-Mg oxides that have an effect of inhibiting Zn evaporation during welding.
Further, when the content of Si in the coatings bath, which is intended for manufacturing the zinc-based coatings layer 20, is too large, the viscosity of the coatings bath may increase more than necessary and the operability during the manufacture of the coated steel material (to be referred to as "coatings operability" below) may decrease. Therefore, the content of Si in the coatings bath is adjusted from the viewpoint of coatings operability. The content of Si in the zinc-based coatings layer 20 is preferably 1.50 mass% or less and more preferably 1.00 mass% or less.

[Fe: 0 mass% or more and 5.00 mass% or less]

Elements constituting the steel material are sometimes contained in the zinc-based coatings layer 20 from the steel material 10 being the base material. In particular, in the hot-dip coatings method, the elements constituting the steel material 10 are easily contained in the zinc-based coatings layer 20 due to interdiffusion of the elements caused by a solid-liquid reaction between the steel material 10 and the zinc-based coatings layer 20. Due to such containing of the elements, a predetermined amount of Fe is often contained in the zinc-based coatings layer 20, and the content is often 0.01 mass% or more. When the above-described interdiffusion is promoted, the adhesiveness between the steel material 10 and the zinc-based coatings layer 20 improves. From the viewpoint of improving adhesiveness between the steel material 10 and the zinc-based coatings layer 20, the content of Fe in the zinc-based coatings layer 20 is preferably 0.20 mass% or more.
Further, Fe may be intentionally added to the coatings bath, which is used when manufacturing the zinc-based coatings layer 20, within a range that does not impair the effects of the present invention. However, when the content of Fe in the coatings bath increases, high melting point intermetallic compounds of Fe and Al are formed in the coatings bath. In this case, such high melting point intermetallic compounds tend to adhere to the zinc-based coatings layer 20 as dross to significantly degrade the appearance quality, which is thus undesirable. The content of Fe in the coatings bath is adjusted from such a viewpoint. The content of Fe in the zinc-based coatings layer 20 is preferably 5.00 mass% or less. The content of Fe in the coatings layer 20 is more preferably 3.00 mass% or less, and further preferably 2.00 mass% or less, 1.00 mass% or less, or 0.50 mass% or less.

◇ Element group B

In another aspect of the zinc-based coatings layer 20 according to this embodiment, the element group B that the zinc-based coatings layer 20 can contain will be explained. At least any of the elements in the element group B described below is an element that can be contained in the zinc-based coatings layer 20 in place of part of Zn being the balance.

[Element group B]: one or two or more selected from the group consisting of Sb: less than 0.50%, Pb: less than 0.50%, and Sr: less than 0.50%

[Sb: 0 mass% or more and 0.50 mass% or less]
[Pb: 0 mass% or more and 0.50 mass% or less]
[Sr: 0 mass% or more and 0.50 mass% or less]

In another aspect of the zinc-based coatings layer 20 according to this embodiment, the case of not containing Sb, Pb, or Sr can also be considered, and thus the lower limit of the content of each of these elements is 0 mass%. On the other hand, when at least any of Sb, Pb, and Sr is contained in the zinc-based coatings layer 20, spangles are formed on the surface of the zinc-based coatings layer 20, thus making it possible to achieve an improvement in metallic luster. Therefore, from the viewpoint of further improving design of the coated steel material, at least any of Sb, Pb, and Sr is preferably contained in the zinc-based coatings layer 20. Such an effect of improving design is exhibited when the content of at least any of Sb, Pb, and Sr is 0.05 mass% or more. Therefore, when at least any of Sb, Pb, and Sr is contained in the zinc-based coatings layer 20, the content of each of these elements is preferably set to 0.05 mass% or more independently.

On the other hand, when the zinc-based coatings layer 20 in which any of the contents of Sb, Pb, and Sr exceeds 0.50 mass% is formed, the amount of dross generated in the coatings bath, which is used for forming the zinc-based coatings layer 20, increases, resulting in that there is a possibility of failing to manufacture a coated steel material having good coatings properties. Therefore, the content of each of Sb, Pb, and Sr in the zinc-based coatings layer 20 is preferably 0.50 mass% or less independently. The content of each of Sb, Pb, and Sr is preferably 0.20 mass% or less independently.

◊ Element group C

In another aspect of the zinc-based coatings layer 20 according to this embodiment, the element group C that the zinc-based coatings layer 20 can contain will be explained. At least any of the elements in the element group C described below is an element that can be contained in the zinc-based coatings layer 20 in place of part of Zn being the balance.

[Element group C]: one or two or more selected from the group consisting of Cu: less than 0.25%, Ti: less than 0.25%, Cr: less than 0.25%, Nb: less than 0.25%, Ni: less than 0.25%, Mn: less than 0.25%, Co: less than 0.25%, and V: less than 0.25%

[Cu: 0 mass% or more and less than 0.25 mass%]
[Ti: 0 mass% or more and less than 0.25 mass%]
[Cr: 0 mass% or more and less than 0.25 mass%]
[Nb: 0 mass% or more and less than 0.25 mass%]
[Ni: 0 mass% or more and less than 0.25 mass%]
[Mn: 0 mass% or more and less than 0.25 mass%]
[Co: 0 mass% or more and less than 0.25 mass%]
[V: 0 mass% or more and less than 0.25 mass%]

In another aspect of the zinc-based coatings layer 20 according to this embodiment, the case of not containing Cu, Ti, Cr, Nb, Ni, Mn, Co, or V can also be considered, and thus the lower limit of the content of each of these elements is 0 mass%. On the other hand, when at least any of Cu, Ti, Cr, Nb, Ni, Mn, Co, and V is contained in the zinc-based coatings layer 20, when such a coated steel material is welded, these elements are incorporated into the Fe-Al-based metal structure produced by welding, which makes it possible to further improve corrosion resistance of a welded zone formed. Such an effect of improving corrosion resistance of the welded zone is exhibited when the content of at least any of Cu, Ti, Cr, Nb, Ni, Mn, Co, and V in the zinc-based coatings layer 20 is 0.05 mass% or more. Therefore, when at least any of Cu, Ti, Cr, Nb, Ni, Mn, Co, and V is contained in the zinc-based coatings layer 20, the content of each of these elements is preferably set to 0.05 mass% or more independently.

On the other hand, when the zinc-based coatings layer 20 in which any of the contents of Cu, Ti, Cr, Nb, Ni, Mn, Co, and V is 0.25 mass% or more is formed, these elements form various intermetallic compounds in the coatings bath, which is intended for forming the zinc-based coatings layer 20, to cause the viscosity of the coatings bath to increase, resulting in that there is a possibility of failing to manufacture a coated steel material having good coatings properties. Therefore, the content of each of Cu, Ti, Cr, Nb, Ni, Mn, Co, and V in the zinc-based coatings layer 20 is preferably set to less than 0.25 mass% independently. The content of each of Cu, Ti, Cr, Nb, Ni, Mn, Co, and V is preferably 0.20 mass% or less independently.

◊ Element group D

In another aspect of the zinc-based coatings layer 20 according to this embodiment, the element group D that the zinc-based coatings layer 20 can contain will be explained. At least any of the elements in the element group D described below is an element that can be contained in the zinc-based coatings layer 20 in place of part of Zn being the balance.

[Element group D]: one or two or more selected from the group consisting of Sn: 20.00% or less, Bi: less than 5.00%, and In: less than 2.00%

[Sn: 0 mass% or more and 20.00 mass% or less]
[Bi: 0 mass% or more and less than 5.00 mass%]
[In: 0 mass% or more and less than 2.00 mass%]

In another aspect of the zinc-based coatings layer 20 according to this embodiment, the case of not containing Sn, Bi, or In can also be considered, and thus the lower limit of each of the contents of these elements is 0 mass%. On the other hand, Sn, Bi, and In can form intermetallic compounds with Mg in the zinc-based coatings layer 20 to improve weldability of the zinc-based coatings layer 20. Further, all these intermetallic compounds have a high melting point, and thus when the coated steel material is welded, they do not evaporate but remain as the intermetallic compounds even after welding. The presence of these elements makes it possible to improve corrosion resistance and anti-corrosion properties, and also makes it possible to improve the corrosion resistance of the welded zone during welding. Such an effect of improving corrosion resistance is exhibited when at least any of the contents of Sn, Bi, and In in the zinc-based coatings layer 20 is 0.05 mass% or more. Therefore, when at least any of Sn, Bi, and In is contained in the zinc-based coatings layer 20, the content of each of these elements is preferably set to 0.05 mass% or more independently.

On the other hand, excessive addition of Sn may increase the amount of the intermetallic compound formed to reduce the corrosion resistance of the zinc-based coatings layer 20 after welding. Further, excessive addition of Bi and In may make the zinc-based coatings layer brittle and likely to peel off, and may additionally reduce the corrosion resistance of the zinc-based coatings layer 20 after welding. These phenomena become pronounced when the content of Sn exceeds 20.00 mass%, when the content of Bi is 5.00 mass% or more, or when the content of In is 2.00 mass% or more. Therefore, the content of Sn is preferably 20.00 mass% or less, the content of Bi is preferably less than 5.00 mass%, and the content of In is preferably less than 2.00 mass%. The content of Sn is more preferably 10.00 mass% or less, the content of Bi is more preferably 3.00 mass% or less, and the content of In is more preferably 1.00 mass% or less.

◇ Element group E

In another aspect of the zinc-based coatings layer 20 according to this embodiment, the element group E that the zinc-based coatings layer 20 can contain will be explained. At least any of the elements in the element group E described below is an element that can be contained in the zinc-based coatings layer 20 in place of part of Zn being the balance.

[Element group E]: one or two or more selected from the group consisting of Ca: 3.00% or less, La: less than 0.50%, Ce: less than 0.50%, and Y: 0.50% or less

[Ca: 0 mass% or more and 3.00 mass% or less]

In another aspect of the zinc-based coatings layer 20 according to this embodiment, the case of not containing Ca can also be considered, and thus the lower limit of the content of Ca is 0 mass%. On the other hand, when Ca is contained in the coatings bath, which is intended for manufacturing the zinc-based coatings layer 20, the amount of dross generated with an increase in the concentration of Mg during the plating operation can be reduced, thereby improving coatings operability.

Further, when Ca is contained in the zinc-based coatings layer 20, it forms intermetallic compounds with Al and Zn. Further, when Si is contained in the zinc-based coatings layer 20 together with Ca, Ca forms intermetallic compounds with Si. These intermetallic compounds have a high melting point and a stable structure, thus making it possible to inhibit liquid metal embrittlement (LME) when welding the coated steel material. When Ca is contained in the zinc-based coatings layer 20, such an effect of improving coatings operability and an effect of inhibiting LME during welding are exhibited by setting the content of Ca to 0.01 mass% or more. The content of Ca in the zinc-based coatings layer 20 is more preferably 0.05 mass% or more.

On the other hand, when the content of Ca in the zinc-based coatings layer 20 exceeds 3.00 mass%, the corrosion resistance as the coated steel material may decrease. From such a viewpoint, the content of Ca in the zinc-based coatings layer 20 is preferably 3.00 mass% or less. The content of Ca in the zinc-based coatings layer 20 is preferably 2.00 mass% or less, and more preferably 1.00 mass% or less.

[La: 0 mass% or more and less than 0.50 mass%]
[Ce: 0 mass% or more and less than 0.50 mass%]
[Y: 0 mass% or more and 0.50 mass% or less]

In another aspect of the zinc-based coatings layer 20 according to this embodiment, the case of not containing La, Ce, or Y can also be considered, and thus the lower limit of the content of each of these elements is 0 mass%. On the other hand, La, Ce, and Y are elements that exhibit almost the same effect as Ca. This is because the atomic radius of each element is close to that of Ca, and when these elements are contained in the zinc-based coatings layer 20, they substitute for Ca.

Such an effect of improving coatings operability and an effect of inhibiting LME during welding are exhibited by setting the content of each of these elements to 0.01 mass% or more independently. Therefore, when at least any of La, Ce, and Y is contained, the content of each of these elements is preferably set to 0.01 mass% or more independently. The content of each of La, Ce, and Y in the zinc-based coatings layer 20 is more preferably 0.05 mass% or more independently.

On the other hand, when the contents of La, Ce, and Y are too large in the coatings bath, which is intended for manufacturing the zinc-based coatings layer 20, the viscosity of the coatings bath may increase more than necessary and the coatings operability may decrease. Therefore, the contents of La, Ce, and Y in the coatings bath are adjusted from the viewpoint of coatings operability. The contents of La, Ce, and Y are preferably less than 0.50 mass%, less than 0.50 mass%, and 0.50 mass% or less respectively independently. The content of each of La, Ce, and Y is preferably 0.10 mass% or less independently.

◊ Element group F

In another aspect of the zinc-based coatings layer 20 according to this embodiment, the element group F that the zinc-based coatings layer 20 can contain will be explained. At least the element in the element group F described below is an element that can be contained in the zinc-based coatings layer 20 in place of part of Zn being the balance.

[Element group F]: B: less than 0.50%

[B: 0 mass% or more and less than 0.50 mass%]

In another aspect of the zinc-based coatings layer 20 according to this embodiment, the case of not containing B can also be considered, and thus the lower limit of the content of B is 0 mass%. On the other hand, when B is contained in the zinc-based coatings layer 20, it becomes effective to further inhibit LME. This is presumably because when B is contained in the zinc-based coatings layer 20, it compounds with at least any of Zn, Al, Mg, and Ca to form various intermetallic compounds. Further, it is thought that with the presence of B in the zinc-based coatings layer 20, B diffuses from the zinc-based coatings layer 20 into the steel material 10, which is effective in further inhibiting LME of the steel material 10 by strengthening grain boundaries. Further, the various intermetallic compounds formed with B have extremely high melting points, and therefore also act to inhibit evaporation of Zn during welding presumably. These improvement effects are exhibited by containing 0.05 mass% or more of B. Therefore, when B is contained, the content of B is preferably 0.05 mass% or more.

On the other hand, when B is excessively contained in the coatings bath in order to contain B in the zinc-based coatings layer 20, a rapid increase in the melting point of coatings is caused and the coatings operability decreases, resulting in that there is a possibility of failing to manufacture a coated steel material excellent in coatings properties. Such a decrease in the coatings operability becomes pronounced when the content of B is 0.50 mass% or more, and thus the content of B is preferably less than 0.50 mass%. The content of B is more preferably 0.10 mass% or less.

[Measurement method of chemical components]

The chemical components of the above-described zinc-based coatings layer 20 can be measured using ICP-AES (Inductively Coupled Plasma Atomic Emission Spectrometry) or ICP-MS (Inductively Coupled Plasma Mass Spectrometry). Incidentally, ICP-AES is used when analyzing chemical components down to 0.1 mass% units, and ICP-MS is used when analyzing chemical components in trace amounts of less than 0.1 mass%. The coated steel material is immersed in a 10% HCl aqueous solution with an inhibitor added thereto for about 1 minute to peel off the zinc-based coatings layer portion, and a solution is prepared in which this zinc-based coatings layer has been dissolved. The obtained solution is analyzed by ICP-AES or ICP-MS, thereby making it possible to obtain chemical components as an overall average of the zinc-based coatings layer.

<<Regarding the coating weight of the zinc-based coatings layer>>

The coating weight of the zinc-based coatings layer 20 as explained above is preferably 10.0 g/m$^2$ or more and more preferably 50.0 g/m$^2$ or more per one side of the steel material, for example. Further, the coating weight of the zinc-based coatings layer 20 is 200.0 g/m$^2$ or less and more preferably 150.0 g/m$^2$ or less per one side of the steel material, for example. The coating weight of the zinc-based coatings layer 20 falls within such a range as described above, and thereby the surface-treated member 1 according to this embodiment can exhibit sufficient corrosion resistance.

Incidentally, such a coating weight of the zinc-based coatings layer 20 is determined by cutting a sample out from the surface-treated member 1 into a size of 30 mm × 30 mm and measuring its mass in advance. A tape seal is applied to one surface of this sample to prevent the zinc-based coatings layer on the one surface from dissolving in the next step. The sample is then immersed in a 10% HCl aqueous solution with an inhibitor added thereto, to peel off the zinc-based coatings layer by pickling, and the mass of the sample after pickling is measured. From variations in the mass of the sample before and after pickling, the coating weight of the zinc-based coatings layer 20 per one side can be determined.

<<Regarding the steel base exposed portion 201 in the zinc-based coatings layer 20>>

Then, the steel base exposed portion 201 present in at least a portion of the zinc-based coatings layer 20 according to this embodiment is explained in detail.

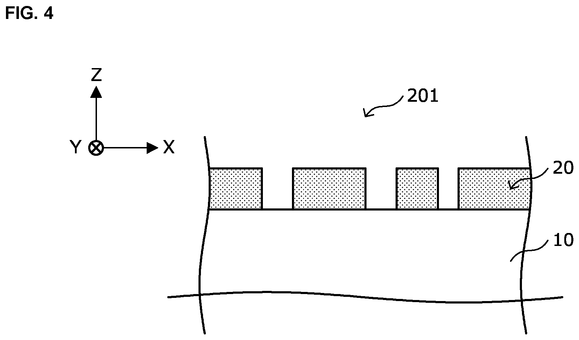

FIG. 4 schematically illustrates a cross section of the surface-treated member 1 illustrated in FIG. 2 when cut in the Z-axis direction along the B-B cutting line. The cross-sectional view illustrated in FIG. 4 corresponds to one obtained by the portion of the surface-treated member 1 according to this embodiment where the steel base exposed portion 201 is present being cut in the thickness direction of the zinc-based coated steel material serving as the raw material of the surface-treated member 1.

As schematically illustrated in FIG. 4, the portion of the surface-treated member 1 according to this embodiment where the steel base exposed portion 201 is present is formed of the surface-treated steel material including the steel material 10 serving as the base material, and the zinc-based coatings layers 20 located on the surfaces of the steel material 10 (namely, the zinc-based coated steel material). Further, the portion where the surface of the steel material 10 (namely, steel base) is exposed is present in at least a portion of the zinc-based coatings layer 20.

As briefly mentioned previously, in the surface-treated member 1 according to this embodiment, the steel base exposed portion 201 is intentionally provided at a specific abundance ratio in a portion of the zinc-based coatings layer 20. As a result, when the portion of the surface-treated member 1 according to this embodiment where the steel base exposed portion 201 is provided is buried in the soil, such corrosion products in a dense state as explained previously can be produced on the surface of the zinc-based coatings layer 20 even in the soil surface portion. This makes the surface-treated member 1 according to this embodiment possible to exhibit excellent corrosion resistance even in the soil at a depth of about several centimeters from the soil surface.

◊ Regarding the method of specifying the position where the steel base exposed portion 201 is present

First, there is explained a method of specifying the position where the steel base exposed portion 201 is present in the zinc-based coatings layer 20 below.

The steel base exposed portion 201 present in the zinc-based coatings layer 20 according to this embodiment is a portion where the zinc-based coatings layer 20 is missing to expose the steel base. Thus, the position of the steel base exposed portion 201 can be specified by performing various color identification tests that cause a color reaction at the portion where the steel base is exposed over the entire surface of the zinc-based coatings layer 20.

Such color identification tests are not particularly limited, and various color identification tests can be applied, but it is preferable to use, for example, the ferroxyl test specified in JIS H8626 (1995) or the pinhole test disclosed in Non-Patent Document ("New Pinhole Test Method for Galvanized Sheet Steel," Shozo MATSUDA, Tadashi TANAKA, and Keiichi TANIKAWA, Metal Surface Technology, vol. 23 (1972), p. 142 to 146). In the two types of color identification tests described above, a reagent for the color reaction is applied to the surface of a test object to cause the color reaction, and then the surface of the test object is covered with a test paper, and the portion where the color reaction has occurred is transferred to the test paper. Therefore, using these color identification tests makes it possible to specify the portion with the steel base exposed portion 201 being present regardless of the shape of the surface-treated member 1.

Here, various reagents used in the color identification test, the test paper and so on used for the transfer of the colored portion, the procedure for the color identification test, and so on only need to be in accordance with those specified in the documents disclosing the respective test methods.

◊ Regarding the presence state of the steel base exposed portion 201

Then, there is explained a presence state of the steel base exposed portion 201 in the zinc-based coatings layer 20 according to this embodiment.

In the surface-treated member 1 according to this embodiment, the presence state of the steel base exposed portion 201 in the zinc-based coatings layer 20 is specified by observing the cross section of the zinc-based coatings layer 20. More specifically, the presence state is specified by observing the cross section obtained by cutting the steel base exposed portion 201 in the thickness direction of the steel material 10 with a microscope, according to the shape of the steel base exposed portion 201 when the zinc-based coatings layer 20 is viewed in plan from above (for example, in the Z-axis direction in FIG. 2). The microscope to be used at this time is not particularly limited as long as it can achieve a magnification that allows cross-section observation. The microscope to be used for observation may be an optical microscope or an electron microscope such as a SEM.

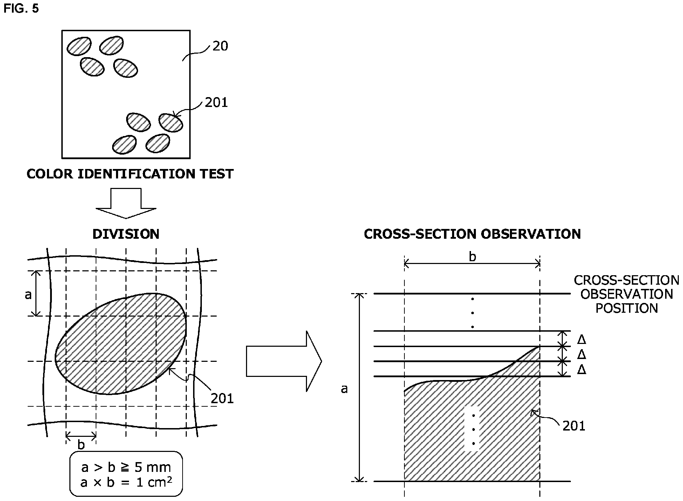

A more specific procedure will be explained below with reference to FIG. 5 to FIG. 7. FIG. 5 to FIG. 7 are explanatory views each for explaining a steel base exposure ratio in the surface-treated member according to this embodiment.

When checking the presence state of the steel base exposed portion 201, as illustrated in the upper left of FIG. 5, first, such a color identification test as described above is performed on the entire surface of the zinc-based coatings layer 20 to specify the positions where the steel base exposed portion 201 is present. Then, as illustrated in the lower left of FIG. 5, each of the specified steel base exposed portions 201 is viewed in plan from above the zinc-based coatings layer 20 (in the Z-axis direction in FIG. 2) to be virtually divided into divisions. During such division, a rectangular-shaped region with a short side b of 5 mm and an area (area obtained by a long side a $\times$ the short side b) of 1 cm$^2$ is used as a unit, and the division is performed.

Then, for each of the virtually divided regions (rectangular-shaped regions), the area ratio of the steel base exposed portion 201 to such a region is calculated. Whether or not the area ratio of the steel base exposed portion 201 to the region (an area of 1 cm$^2$) is 3% or more is determined for all the regions.

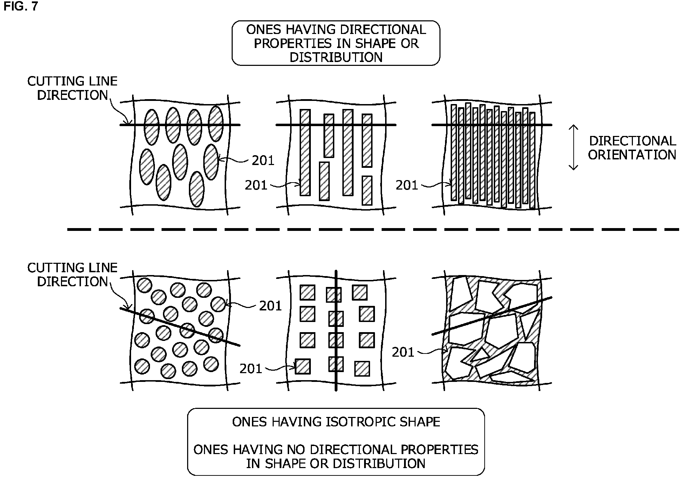

Then, all the regions (rectangular-shaped regions) with the area ratio of the steel base exposed portion 201 being 3% or more are set as such a target region for the cross-section observation as illustrated in the lower right of FIG. 5. As schematically illustrated in the lower right of FIG. 5, the surface-treated member 1 corresponding to the region that draws attention is cut at intervals of $\Delta = 50$ $\mu$m. All of the obtained cross sections are observed with a microscope to calculate the later-described steel base exposure ratio. Incidentally, the cutting direction for obtaining such a cross section as illustrated in the lower right of FIG. 5 will be explained again below with reference to FIG. 7.

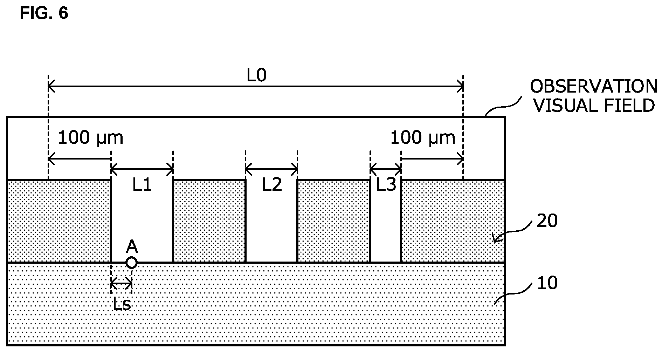

By such microscopic observation as described above, such an observation visual field as schematically illustrated in FIG. 6, for example, can be obtained for each cross section. Here, for such microscopic observation as described above, it is only necessary to use an optical microscope (for example, ECLIPSE LV150 manufactured by NIKON CORPORATION, or the like) to select a magnification of about 100 times.

Within such an observation visual field as illustrated in FIG. 6, the steel base exposed portion 201 located on the leftmost side of the visual field and the steel base exposed portion 201 located on the rightmost side of the visual field are specified. Then, as illustrated in FIG. 6, the position 100 $\mu$m from the left-side end of the steel base exposed portion 201 located on the leftmost side toward the left-side end of the visual field is set as a starting point and the position 100 $\mu$m from the right-side end of the steel base exposed portion 201 located on the rightmost side toward the right-side end of the visual field is set as an end point, and the length between the starting point and the end point is measured and set as a reference length L0.

Further, within such an observation visual field as illustrated in FIG. 6, the length of the steel base exposed is measured for each of the present steel base exposed portions 201. The total of the lengths of the steel bases exposed is calculated and set as $\Sigma$Li (i is an integer parameter indicating the number of steel base exposed portions 201 present within the observation visual field). In the example illustrated in FIG. 6, three steel base exposed portions 201 are present within the observation visual field, and $\Sigma$Li = L1 + L2 + L3 is established.

L0 and $\Sigma$Li are measured as above, and then the value (unit: %) obtained by ($\Sigma$Li/L0) $\times$ 100 is defined as the steel base exposure ratio of the cross section that draws attention.

In the steel base exposed portion 201 of the surface-treated member 1 according to this embodiment, at least one cross section where such a steel base exposure ratio as described above falls within a range of 1.0 to 40.0% is present. The steel base exposed portion 201 is in such a presence state as above, thereby making it possible to produce corrosion products in a dense state different from those in the atmosphere, starting from such an exposed portion. Such corrosion products protect the steel base and the zinc-based coatings layer in the vicinity thereof, and even when the steel base exposed portion 201 of the surface-treated member 1 according to this embodiment is buried in the soil, the corrosion resistance of the surface-treated member 1 can be secured.

The number of cross sections having the steel base exposure ratio falling within a range of 1.0 to 40.0% should be as large as possible, and the upper limit of the number is not specified in particular. Further, it is more preferable that the steel base exposure ratio should fall within a range of 1.0 to 40.0% in all of the obtained cross sections.

Further, from such a viewpoint of corrosion resistance as described above, it is more preferable that at least one or more cross sections each having the steel base exposure ratio falling within a range of 5.0 to 40.0% should be present in the surface-treated member 1 according to this embodiment. The number of cross sections having the steel base exposure ratio falling within a range of 5.0 to 40.0% should be as large as possible, and the upper limit of the number is not specified in particular. Further, it is more preferable that the steel base exposure ratio should fall within a range of 5.0 to 40.0% in all the obtained cross sections.

Further, in the surface-treated member 1 according to this embodiment, in the cross section having the steel base exposure ratio calculated as described above falling within a range of 1.0 to 40.0%, the shortest distance from any point on the surface of the exposed steel material 10 to the zinc-based coatings layer 20 is greater than 0 $\mu$m and 50.0 $\mu$m or less. For example, in the example illustrated in FIG. 6, when focusing on a point A on the surface of the exposed steel material 10, the shortest distance to the zinc-based coatings layer 20 corresponds to a length Ls in the drawing. The case where this shortest distance is greater than 50.0 $\mu$m means that the width of the steel base exposed portion 201 is too large. In this case, when the steel base exposed portion 201 is buried in the soil, the dissolution of Zn from the zinc-based coatings layer 20 into the steel base exposed portion 201 is not in time for inhibition (prevention) of corrosion, failing to secure the corrosion resistance of the surface-treated member 1. The size of such a shortest distance is preferably greater than 0 $\mu$m and 40.0 $\mu$m or less, and more preferably greater than 0 $\mu$m and 30.0 $\mu$m or less.

Incidentally, such various lengths in the observation visual field as described above can be measured using a length measurement function or the like implemented in the microscope used.

In the surface-treated member 1 according to this embodiment, the ratio of the total area of divisions where the cross section having the steel base exposure ratio falling within a range of 1.0 to 40.0% is obtained to the area of the portion buried in the soil is preferably 5.0% or more. The total area of the above-described divisions becomes 5.0% or more relative to the area of a portion to be buried, and thereby the surface-treated member 1 according to this embodiment exhibits more excellent corrosion resistance. The ratio of the total area of divisions where the cross section having the steel base exposure ratio falling within a range of 1.0 to 40.0% is obtained to the area of the portion buried in the soil is more preferably 10.0% or more. Incidentally, the upper limit value of the above-described ratio is not specified in particular, and may be 100%.

Further, when the steel base exposed portion 201 is observed in cross section as described above, the total area of the regions where the cross section having the steel base exposure ratio being greater than 40.0% is given (the total area of the corresponding regions when viewed in plan from above) is 5% or less relative to the entire area of the steel base exposed portion 201 that draw attention. When such a ratio of the total area exceeds 5%, the region where the zinc-based coatings layer 20 is excessively peeled off to expose the steel base becomes too large, resulting in a decrease in the corrosion resistance of the surface-treated member 1. Incidentally, a smaller ratio of such a total area is better, and it is most preferable that the ratio should be 0%.

◊ Regarding the direction of the cutting line when calculating the steel base exposure ratio

Here, the direction of the cutting line when performing such a cross-section observation as described above is explained with reference to FIG. 7. In the surface-treated member 1 according to this embodiment, when specifying the steel base exposure ratio, the surface-treated member 1 is cut in the thickness direction of the steel material 10 to obtain the cross section as described above. At this time, the direction of the cutting line is determined according to the shape and distribution of the steel base exposed portion 201 when the zinc-based coatings layer 20 is viewed in plan from above.

FIG. 7 illustrates typified examples of the shape and distribution of the steel base exposed portion 201 when viewed in plan macroscopically from above the zinc-based coatings layer 20 (in the Z-axis direction). In the surface-treated member 1 according to this embodiment, the shapes and the distributions of the steel base exposed portions 201 are roughly classified into those having directional properties as illustrated in a group in the upper part of FIG. 7, those having an isotropic shape as illustrated in a group in the lower part of FIG. 7, and those having no directional properties in shape or distribution.

In the group illustrated in the upper part in FIG. 7, there exist the steel base exposed portions 201 having a directional orientation (the vertical direction of the paper in the case of the upper part in FIG. 7), such as the steel base exposed portions 201 each having a substantially elliptical shape and distributed with major axis directions of the ellipses being substantially parallel to each other (the leftmost drawing, the upper part of FIG. 7) and the steel base exposed portions 201 each having a substantially rectangular shape and distributed with long side directions of the rectangles being substantially parallel to each other (the middle and rightmost drawings, the upper part of FIG. 7). In such a case, in this embodiment, the direction perpendicular to the directional orientation is set as the direction of the cutting line.

Further, in the group illustrated in the lower part of FIG. 7, there exist the steel base exposed portions 201 each having an isotropic shape, or the steel base exposed portions 201 having no directional properties in shape or distribution, such as the circular-shaped steel base exposed portions 201 distributed (the leftmost drawing, the lower part of FIG. 7), the square-shaped steel base exposed portions 201 randomly distributed (the middle drawing, the lower part of FIG. 7), and the zinc-based coatings layer 20 distributed in an island-like pattern (the rightmost drawing, the lower part of FIG. 7). In such a case, in this embodiment, the direction of the cutting line is not particularly specified, and any direction may be set as the direction of the cutting line.

◊ Regarding the relationship between the steel base exposure ratio and the coatings weight

The present inventors actually manufactured surface-treated members while changing the coatings weight per side of the zinc-based coatings layer 20 and the steel base exposure ratio, and then buried the manufactured surface-treated members in the soil to verify their corrosion resistance. Then, on a coordinate plane where the horizontal axis defines the coatings weight per side (unit: g/m$^2$) and the vertical axis defines the upper limit of measured values of the obtained steel base exposure ratios (unit: %), how the results obtained by verifying whether the corrosion resistance is good or not are distributed was studied. As a result, it became clear that the surface-treated member 1 according to this embodiment exhibits more excellent corrosion resistance when both the conditions described in Formula s (101) and (102) below are established.

$$A \leq 0.8 \times 10^{-1} \times B + 28.0 \ ... \ \text{Formula (101)}$$

$$A \leq 40.0 \ ... \ \text{Formula (102)}$$

Here, in Formula (101) and Formula (102) described above, a parameter A is the upper limit value (unit: %) of measured values of the obtained steel base exposure ratios, and a parameter B is the coating weight per side (unit: g/m$^2$) of the zinc-based coatings layer 20. The detailed reason why more excellent corrosion resistance is exhibited when Formula (101) and Formula (102) described above are established remain unclear. However, the present inventors presume that this is because the relationship between the area of the exposed steel base and the amount of Zn dissolved from the zinc-based coatings layer 20 commensurate with such an area is appropriate.

Further, when the coating weight of the zinc-based coatings layer 20 per side falls within a range of 50.0 to 150.0 g/m$^2$ and Formula (101) and Formula (102) described above are both established, the surface-treated member 1 according to this embodiment exhibits still more excellent corrosion resistance.

The surface-treated member 1 according to this embodiment has been explained in detail with reference to FIG. 2 to FIG. 7 above.

Such a surface-treated member 1 according to this embodiment as explained above can exhibit excellent corrosion resistance even in the soil at a depth of about several centimeters from the soil surface by changing the state of the zinc-based coatings layer provided as the surface-treated layer depending on the corrosive environment to which the surface-treated member 1 is exposed. Here, the soil in which the surface-treated member 1 according to this embodiment can be buried is not particularly limited. However, for example, it is presumed that the properties of the surface-treated member 1 according to this embodiment will be more favorably effective as long as the soil satisfies the following conditions.

Examples of the soil suitable for burial include soil with a pH of about 3 to 12, which allows Fe dissolution to proceed easily, soil with a Cl ion concentration of 5 mg or more per kg of soil, soil in salt-damaged areas, soil where a snow-melting agent is often sprayed, and so on.

(Regarding modified examples of the method of calculating the steel base exposure ratio)

In the above-described embodiment, the method of calculating the steel base exposure ratio by observing the cross section of the zinc-based coatings layer 20 with a microscope has been explained. Such a method is preferable because focusing on the cross section makes it possible to specify the steel base exposure ratio regardless of the outer shape of the surface-treated member 1 (for example, whether it has a shape with many flat portions, a shape with many curved surfaces, or another shape).

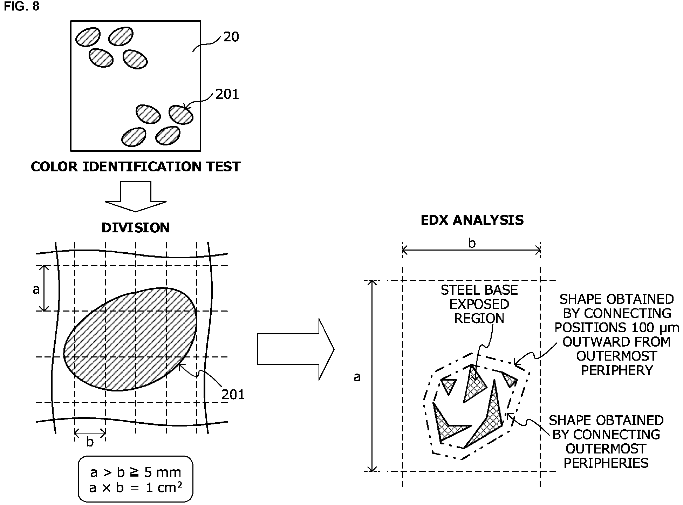

There will be briefly explained, with reference to FIG. 8, a method of calculating the steel base exposure ratio by analyzing the surface of the zinc-based coatings layer 20 using an EDX (Energy Dispersive X-ray Spectroscopy) analyzer installed in an SEM (for example, JSM-7000F manufactured by JEOL Ltd., or the like) and mapping the obtained analysis result, rather than such a method of calculating the steel base exposure ratio from cross section microscopic observation as explained previously. The calculation method to be explained below is a method particularly useful when a certain range of the zinc-based coatings layer can be easily viewed in plan from above, such as the case where the outer shape of the surface-treated member 1 is a shape consisting of gently curved flat portions or a shape consisting of flat surfaces. In this case, in place of such a method of calculating the steel base exposure ratio from cross section as explained previously, the method to be explained below may be employed.

FIG. 8 is an explanatory view for explaining a modified example of the steel base exposure ratio in the surface-treated member 1 according to this embodiment. Here, the procedure from performing a color identification test on the surface of the zinc-based coatings layer 20 to virtually dividing the steel base exposed portion 201 into rectangular divisions as a unit is the same as that illustrated in FIG. 5, and therefore a detailed explanation thereof will be omitted below.

In this modified example as well, among the virtually divided regions, the region where the area ratio of the steel base exposed portion 201 to the region (an area of 1 cm$^2$) is 3% or more is set as a target for the EDX analysis.

In this modified example, the entire region to be analyzed is observed from the surface using SEM-EDX, and the state of the elements Zn, Al, and Mg distributed in the region to be investigated is analyzed. The observation conditions for SEM-EDX at this time only need to be set as follows: accelerating voltage: 15 kV, irradiation current: 0.005 nA, the number of sweeps: 10 times, and observation magnification: 500 times, for example. When performing such an observation, a mapping analysis is performed for at least five elements O, Zn, Al, Mg, and Fe, and the mapping analysis may be performed for all elements.

Based on the obtained measurement results, the state of the elements Zn, Al, and Mg distributed is two-dimensionally mapped, and the region of the obtained distribution where the content of Zn is 1.0 mass% or less, the content of Al is 1.0 mass% or less, and the content of Mg is 0.5 mass% or less is treated as a steel base exposed region. By doing this, it is possible to specify a specific shape of the steel base exposed region and the state of the steel base exposed regions distributed within each division, as schematically illustrated in the lower right drawing of FIG. 8. The total area of the steel base exposed regions obtained as above (in the example of FIG. 8, the total area of five steel base exposed regions) is calculated.

Meanwhile, the outermost peripheries of the specified steel base exposed regions are connected to obtain such a shape connecting the outermost peripheries as illustrated in the lower right drawing of FIG. 8. Positions 100 $\mu$m further outward from this outermost periphery are connected to specify an obtained shape. The area of the shape obtained by connecting the positions 100 $\mu$m outward from this outermost periphery is set as the reference area when calculating the steel base exposure ratio.

Then, the value (unit: %) expressed as (the total area of steel base exposed regions/the reference area) $\times$ 100 only needs to be treated as the steel base exposure ratio.

Incidentally, in this modified example, when the entire region of 1 cm$^2$ is included in the shape obtained as a result of connecting the outermost peripheries, the area of the division as a unit (1 cm$^2$) is set as the reference area. Further, for the divisions whose reference area is 0.3 cm$^2$ or more, the steel base exposure ratio is calculated.

The modified example of the method of calculating the steel base exposure ratio has been explained briefly above.

(Regarding the manufacturing method of the surface-treated member)

There will be explained an example of the manufacturing method of the surface-treated member 1 according to this embodiment below.

<Manufacturing method of the surface-treated steel material that serves as the raw material>

The surface-treated steel material serving as the raw material of the surface-treated member 1 according to this embodiment is manufactured by using such a steel material 10 as described above as a base material and forming a zinc-based coatings layer on the surfaces of such a steel material 10.

Here, to the formation of the zinc-based coatings layer, in addition to the hot-dip coatings method, a thermal spraying method, a cold spraying method, a sputtering method, a vapor deposition method, an electroplating method, or the like can be applied. However, the hot-dip coatings method is the most preferable in terms of cost.

Then, such specific process treatments as will be explained below are performed at a desired position (more specifically, a portion where a steel base exposed portion is to be formed) of the obtained coated steel material (the steel material 10 having the zinc-based coatings layers), thereby forming the steel base exposed portion in the zinc-based coatings layer. This makes it possible to manufacture the surface-treated steel material that serves as the raw material of the surface-treated member 1 according to this embodiment.

There will be explained in detail an example of the manufacturing method for obtaining the surface-treated steel material according to this embodiment using the hot-dip coatings method below.

In the manufacturing step of such a surface-treated steel material, a steel sheet as an example of the steel material 10 to be used as a base material is first rolled by a Sendzimir method to a desired sheet thickness, and then is coiled into a coil and installed in a hot-dip coatings line.

In the hot-dip coatings line, sheet passing of the steel sheet is continuously performed while the steel sheet being uncoiled from the coil. At this time, by an annealing facility installed on the line, the steel sheet is heated and reduced at 800°C in an N$_2$-5% H$_2$ gas atmosphere under the environment having an oxygen concentration of 20 ppm or less where oxidation is unlikely to occur, for example, and then air-cooled with N$_2$ gas to around a bath temperature of a coatings bath at a subsequent stage + 20°C and then immersed in the coatings bath.

Here, in the coatings bath, a coatings alloy in a molten state, which contains such chemical components as described above, is prepared beforehand. The bath temperature of the coatings bath is set to the melting point of the coatings alloy or higher (for example, about 460 to 660°C).

When preparing the material for the coatings alloy, pure metal (with a purity of 99% or higher) is preferably used as the alloy material for the preparation. First, a predetermined amount of alloy metal is mixed so as to obtain the composition of such a coatings layer as described above, and the mixture is completely melted into an alloy using a high-frequency induction furnace, an arc furnace, or other furnaces under vacuum or in an inert gas replacement state. Further, the alloy mixed with the predetermined components (the composition of the above-described coatings layer) is melted in the atmosphere, and the resulting melt is used as the coatings bath.

Incidentally, there is no particular restriction on using pure metals in such preparation of the coatings alloy as described above, and existing Zn alloys, Mg alloys, and Al alloys may be melted and used. In this case, there is no problem as long as a predetermined composition alloy with few impurities is used.

After the steel sheet is immersed in such a coatings bath as described above, it is pulled up at a predetermined speed. At this time, the coatings weight is controlled by $N_2$ wiping gas, for example, so that the zinc-based coatings layer formed obtains a desired thickness. As for the conditions other than the bath temperature here, general coatings operating conditions only need to be applied, and no special facilities or conditions are required.

Further, various heat treatments may be performed on the coatings alloy in a molten state located on the steel sheet as necessary.

Then, a process treatment such as a scratch imparting treatment or a bending process treatment is performed on the zinc-based coatings layer at a desired position of the manufactured surface-treated steel material. As a result, the steel base exposed portion 201 is formed in the treated portion.

For example, when forming the steel base exposed portion 201 by the scratch imparting treatment, a blade is used that has a length of 50 $\mu$m or more at a portion where the width of the tip is 30 $\mu$m or less and that is sufficiently hard compared to the coatings structure, and such a blade is pressed perpendicularly against the steel sheet. Then, a constant pressure is applied along the direction in which the blade penetrates the steel sheet. It is only necessary to move the blade linearly in this state, to thereby make scratches in the surface of the zinc-based coatings layer. The steel base exposure ratio can be varied by the number of scratches made per unit area. Further, even when the other manufacturing conditions are not changed, such a blade with a wide cutting edge as described above is used to make scratches, thereby making it possible to control the shortest distance from any point on the steel base exposed portion to the zinc-based coatings layer to a desired condition by utilizing deflections of the blade caused by pressure application, vibrations of the blade caused by moving the blade, or another factor.

Here, as a method of applying pressure to the blade, for example, placing a weight of 3 kg or 5 kg on the blade, or the like is considered. This pressure is sufficient for scratching the zinc-based coatings layer, but is so low that it barely scratches the steel material. Further, there is no particular restriction on the speed of moving the blade. Incidentally, when the blade and the steel material slip, there are methods such as setting the speed of moving the blade to 50 cm/sec or less, from the viewpoint of preventing the blade from failing to make scratches.

Further, for example, when forming the steel base exposed portion 201 by the bending process treatment, a hydraulic bending machine consisting of two parts, a die and a press machine, may be used. Here, the die is composed of, for example, a convex die with a tip in the shape of a right-angled isosceles triangle and a concave die with a depression having the same shape as the tip of the convex die, and the tip of the convex die is rounded with a radius R (unit: mm) rather than having an acute angle.

A desired coated steel sheet is placed between such convex and concave dies as described above, and both the dies are pressed together with a press machine to thereby process the zinc-based coatings layer. At this time, a sheet thickness t (unit: mm) of the coated steel sheet, the radius R (unit: mm) of the tip of the convex die, and a pressing speed V (unit: cm/s) of the press machine are controlled, thereby making it possible to form the steel base exposed portion at a desired position in the zinc-based coatings layer.

At this time, t/R, which is the ratio of the sheet thickness t to the radius R of the tip of the convex die, is controlled so as to satisfy the relationship of $0.6 \leq t/R \leq 4.0$. By setting such a process condition, significant elongation is applied to the zinc-based coatings layer to thereby cause coatings cracks and enable the steel base exposure ratio to fall within a desired range. Further, the pressing speed V of the press machine from the time the convex die comes into contact with the zinc-based coatings layer until the process is completed is set to 1 cm/s or less. By reducing the process speed to the minimum as above, it is possible to prevent the occurrence of large localized cracks and control the size of the steel base exposed portion 201.

An example of the manufacturing method of the surface-treated steel material according to this embodiment has been specifically explained above.

<Manufacturing method of the surface-treated member>

The surface-treated steel material obtained as described above is used as the raw material to manufacture the surface-treated member according to this embodiment. Here, when obtaining parts for manufacturing the surface-treated member from the surface-treated steel material, various shaping process treatments can be utilized, such as various forming process treatments and joining treatments by fastening members such as bolts and rivets and welding treatments. By appropriately combining these treatments, the surface-treated member having a desired shape can be manufactured from the surface-treated steel material.

An example of the manufacturing method of the surface-treated member according to this embodiment has been explained above.

Incidentally, in the above-described explanation, the case where the steel base exposed portion 201 is formed by performing the strain imparting treatment on the surface-treated steel material has been explained, but the strain imparting treatment may be performed as part of the process treatment when manufacturing the surface-treated member from the surface-treated steel material without performing the strain imparting treatment at the stage when the surface-treated steel material is manufactured. Further, the process treatment itself when manufacturing the surface-treated member from the surface-treated steel material may be utilized as the strain imparting treatment for forming the steel base exposed portion 201.

EXAMPLES

Hereinafter, the surface-treated member according to the present invention will be specifically explained with reference to examples and comparative examples. Incidentally, the following examples are merely examples of the surface-treated member according to the present invention, and the surface-treated member according to the present invention is not limited to the following examples.

In a test example to be described below, coated substrates illustrated in Table 1 below (all manufactured by NIPPON STEEL CORPORATION) were used, and such coated substrates were each cut into a size of 100 mm × 200 mm. Then, coatings was performed using an in-house batch-type hot-dip coatings test apparatus, and a plurality of plated steel materials having compositions of coatings layers illustrated in Table 2 below were manufactured for each level.

[Table 1]

TABLE 1

|   | COATED SUBSTRATE |
|---|---|
| a | COLD-ROLLED STEEL SHEET |
| b | Ni-COATED COLD-ROLLED STEEL SHEET (Ni COATINGS WEIGHT 0.5 g/m$^2$) |
| c | Ni-COATED COLD-ROLLED STEEL SHEET (Ni COATINGS WEIGHT 2.0 g/m$^2$) |

[Table 2]

TABLE 2

|   | COATINGS COMPOSITION (MASS%) |
|---|---|
| A | Zn - 0.18%Al |
| B | Zn - 6.0%Al - 3.0%Mg |
| C | Zn - 11.0%Al - 3.0%Mg - 0.2%Si |
| D | Zn - 16.0%Al - 6.0%Mg - 0.2%Si |
| E | Zn - 19.0%Al - 6.0%Mg - 1.5%Sn - 0.5%Ca - 0.2%Si |
| F | Zn - 24.0%Al - 12.0%Mg - 0.5%Ca - 1.2%Si |

Each of the obtained coated steel materials was subjected to such a scratching process or bending process as described above at substantially the center of the surface of the coatings layer to form steel base exposed portions, and thereby a surface-treated member was manufactured.

The scratching process was performed by using a blade sufficiently harder than the coatings layer and forming parallel linear scratches. At this time, the maximum width in the 50 μm range at the tip of the blade used for scratching and the interval between parallel scratches were adjusted, and thereby a desired steel base exposure ratio was obtained. Incidentally, for the scratching process, a 3kg weight was used to apply pressure to the blade, and the speed of moving the blade was set to 50 cm/sec. By such a scratching process treatment, such steel base exposed portions having directional properties in the distribution as illustrated in the upper right drawing of FIG. 7 were formed at substantially the center of the surface of each of the surface-treated members.

Further, as the bending process, a bending process using a hydraulic bending machine was performed. During the bending process, the sheet thickness t (unit: mm) of the coated steel sheet, the radius R (unit: mm) of the tip of the convex die, and the pressing speed V (unit: cm/s) of the press machine were controlled to obtain a desired steel base exposure ratio. By such a bending process treatment, such steel base exposed portions having directional properties in the distribution as illustrated in the upper middle drawing of FIG. 7 were formed at substantially the center of the surface of each of the surface-treated members.

For the surface-treated members obtained by the above-described two types of processes, the steel base exposure ratio, the shortest distance to the zinc-based coatings layer, the total area of divisions where the cross section having the steel base exposure ratio falling within a range of 1.0 to 40.0% is obtained, and the total area of divisions where the cross section having the steel base exposure ratio being greater than 40.0% is obtained were each measured according to such methods by the cross-section observation as previously explained. Here, as the color identification test, the ferroxyl test specified in JIS H8626 (1995) was performed. Further, as the optical microscope, an ECLIPSE LV150 manufactured by NIKON CORPORATION was used, and its magnification was set to 100 times.

The results obtained by performing the scratching process are summarized in Table 3-1 to Table 3-3 below, and the results obtained by performing the bending process are summarized in Table 4-1 to Table 4-3 below. Incidentally, in Table 3-1 to Table 4-3 below, the column "COATINGS WEIGHT" indicates the coatings weight per side, and the column "STEEL BASE EXPOSURE RATIO" indicates the upper limit of the obtained steel base exposure ratios. Further, in Table 3-1 to Table 4-3 below, the column "LONGEST ONE OF THE SHORTEST DISTANCES" essentially indicates the value obtained by measuring the shortest distance from the center of the steel base exposed portion to the zinc-based coatings layer at the position where the width of the steel base exposed portion is the widest.

The corrosion resistance of each of the surface-treated members obtained was evaluated by the following two test methods.

(Test method 1: Evaluation of corrosion resistance in general soil)

The surface-treated members obtained as described above with the adjusted steel base exposed condition were buried in the soil and their corrosion resistances were evaluated. As the soil, silica sand with an average particle size of 300 μm was used. The cover thickness (distance from the surface of the zinc-based coatings layer to the soil surface) was set to 20 mm. After burial, in order to simulate general soil, ion-exchanged water containing 0.03 mass% of NaCl was dropped onto the soil to adjust the water content to 100%. Then, the following drying and wetting steps were performed 20 times repeatedly.

Drying step: Store at 30°C for seven days
Wetting step: Drop ion-exchanged water to adjust the water content to 100%

After the above-described test was performed, the surface-treated members were each pickled with hydrochloric acid to remove the coatings layer and corrosion products. Then, the corrosion condition of the steel materials was examined using a shape measuring device (VR-5000 manufactured by KEYENCE CORPORATION). The evaluation criteria are as follows. Grades A, B, and C were considered a pass. The results obtained are summarized in Table 2 below.

Grade A: No pits formed in the steel material.
B: Pits having a depth of less than 10 μm formed in the steel material.
C: Pits having a depth of 10 μm or more and less than 50 μm formed in the steel material.
D: Pits having a depth of 50 μm or more and less than 100 μm formed in the steel material.
E: Pits having a depth of 100 μm or more formed in the steel material.

(Test method 2: Evaluation of corrosion resistance in acid soil)

The surface-treated members obtained as described above with the adjusted steel base exposed condition were buried in the soil and their corrosion resistances were evaluated. As the soil, silica sand with an average particle size of 100 μm was used. The cover thickness was set to 50 mm. After burial, in order to simulate the acid soil, an aqueous HCl solution prepared by adding HCl to ion-exchanged water to adjust the pH to 4 was dropped onto the soil to adjust the water content to 100%. Then, the following drying and wetting steps were performed 20 times repeatedly.

Drying step: Store at 30°C for seven days

Wetting step: Drop ion-exchanged water to adjust the water content to 100%

After the above-described test was performed, the surface-treated members were each pickled with hydrochloric acid to remove the coatings layer and corrosion products. Then, the corrosion condition of the steel materials was examined using a shape measuring device (VR-5000 manufactured by KEYENCE CORPORATION). The evaluation criteria are as follows. Grades A, B, and C were considered a pass. The results obtained are summarized in Table 2 below.

Grade A: No pits formed in the steel material.
B: Pits having a depth of less than 10 $\mu$m formed in the steel material.
C: Pits having a depth of 10 $\mu$m or more and less than 50 $\mu$m formed in the steel material.
D: Pits having a depth of 50 $\mu$m or more and less than 100 $\mu$m formed in the steel material.
E: Pits having a depth of 100 $\mu$m or more formed in the steel material.

[Table 3-1]

TABLE 3-1

| No. | CATEGORY | COATED SUBSTRATE | ZINC-BASED COATINGS LAYER | | | SCRATCHING PROCESS CONDITION | | STEEL BASE EXPOSURE RATIO (%) | LONGEST ONE OF THE SHORTEST DISTANCES (μm) | TOTAL OF AREAS WHERE STEEL BASE EXPOSURE RATIO IS GREATER THAN 40.0% (%) | RATIO OF STEEL BASE EXPOSED PORTION IN SOIL (%) | CORROSION RESISTANCE EVALUATION | |
|---|---|---|---|---|---|---|---|---|---|---|---|---|---|
| | | | COATINGS TYPE | COATINGS WEIGHT (g/m²) | FORMULA(1) RIGHT SIDE | BLADE WIDTH (μm) | INTERVAL (μm) | | | | | IN GENERAL SOIL | IN ACID SOIL |
| 1 | EXAMPLE | a | A | 27.0 | 30.2 | 25.0 | 75.0 | 29.3 | 31.2 | 0.0 | 1.1 | C | C |
| 2 | EXAMPLE | a | A | 49.3 | 31.9 | 25.0 | 75.0 | 29.1 | 34.5 | 0.0 | 3.5 | C | C |
| 3 | EXAMPLE | a | A | 50.6 | 32.0 | 25.0 | 175.0 | 12.4 | 31.6 | 0.0 | 3.7 | C | C |
| 4 | EXAMPLE | a | A | 51.4 | 32.1 | 25.0 | 75.0 | 30.8 | 34.0 | 0.0 | 2.1 | C | C |
| 5 | EXAMPLE | a | A | 51.7 | 32.1 | 25.0 | 75.0 | 25.1 | 31.5 | 0.0 | 1.7 | C | C |
| 6 | EXAMPLE | a | A | 75.6 | 34.0 | 25.0 | 75.0 | 29.2 | 35.4 | 0.0 | 2.8 | C | C |
| 7 | EXAMPLE | a | A | 99.4 | 36.0 | 25.0 | 75.0 | 28.6 | 34.8 | 0.0 | 2.9 | C | C |
| 8 | EXAMPLE | a | A | 99.0 | 35.9 | 25.0 | 175.0 | 11.7 | 34.0 | 0.0 | 2.7 | C | C |
| 9 | EXAMPLE | a | A | 99.1 | 35.9 | 25.0 | 75.0 | 28.9 | 33.2 | 0.0 | 1.4 | C | C |
| 10 | EXAMPLE | a | A | 98.3 | 35.9 | 25.0 | 75.0 | 27.2 | 35.3 | 0.0 | 1.1 | C | C |
| 11 | EXAMPLE | a | A | 123.3 | 37.9 | 25.0 | 75.0 | 31.2 | 35.0 | 0.0 | 2.3 | C | C |
| 12 | EXAMPLE | a | A | 151.1 | 40.1 | 25.0 | 75.0 | 29.4 | 31.2 | 0.0 | 3.3 | C | C |
| 13 | EXAMPLE | a | A | 151.0 | 40.1 | 25.0 | 175.0 | 13.9 | 34.5 | 0.0 | 2.8 | C | C |
| 14 | EXAMPLE | a | A | 151.2 | 40.1 | 25.0 | 75.0 | 27.2 | 34.4 | 0.0 | 1.3 | C | C |
| 15 | EXAMPLE | a | A | 151.0 | 40.1 | 25.0 | 75.0 | 27.9 | 33.8 | 0.0 | 3.6 | C | C |
| 16 | EXAMPLE | a | A | 173.4 | 41.9 | 25.0 | 75.0 | 27.0 | 31.4 | 0.0 | 1.7 | C | C |
| 17 | EXAMPLE | a | A | 200.4 | 44.0 | 25.0 | 75.0 | 27.8 | 33.6 | 0.0 | 2.0 | C | C |
| 18 | EXAMPLE | a | A | 298.4 | 51.9 | 25.0 | 75.0 | 25.6 | 32.2 | 0.0 | 2.5 | C | C |
| 19 | EXAMPLE | a | B | 24.8 | 30.0 | 25.0 | 75.0 | 27.1 | 31.9 | 0.0 | 1.5 | B | C |
| 20 | EXAMPLE | a | B | 48.2 | 31.9 | 25.0 | 75.0 | 24.9 | 31.9 | 0.0 | 2.3 | B | C |

(continued)

| No. | CATEGORY | COATED SUBSTRATE | ZINC-BASED COATINGS LAYER | | | SCRATCHING PROCESS CONDITION | | STEEL BASE EXPOSURE RATIO (%) | LONGEST ONE OF THE SHORTEST DISTANCES (μm) | TOTAL OF AREAS WHERE STEEL BASE EXPOSURE RATIO IS GREATER THAN 40.0% (%) | RATIO OF STEEL BASE EXPOSED PORTION IN SOIL (%) | CORROSION RESISTANCE EVALUATION | |
|---|---|---|---|---|---|---|---|---|---|---|---|---|---|
| | | | COATINGS TYPE | COATINGS WEIGHT (g/m²) | FORMULA(1) RIGHT SIDE | BLADE WIDTH (μm) | INTERVAL (μm) | | | | | IN GENERAL SOIL | IN ACID SOIL |
| 21 | EXAMPLE | a | B | 73.7 | 33.9 | 25.0 | 75.0 | 25.8 | 32.5 | 0.0 | 3.6 | B | B |
| 22 | EXAMPLE | a | B | 98.7 | 35.9 | 25.0 | 75.0 | 30.1 | 32.4 | 0.0 | 1.2 | C | B |
| 23 | EXAMPLE | a | B | 98.1 | 35.8 | 25.0 | 75.0 | 27.0 | 34.5 | 0.0 | 3.2 | B | B |
| 24 | EXAMPLE | a | B | 101.4 | 36.1 | 25.0 | 175.0 | 14.5 | 35.7 | 0.0 | 1.5 | B | B |
| 25 | EXAMPLE | a | B | 100.1 | 36.0 | 25.0 | 75.0 | 29.3 | 35.7 | 0.0 | 4.0 | C | B |
| 26 | EXAMPLE | a | B | 126.4 | 38.1 | 25.0 | 75.0 | 29.5 | 34.8 | 0.0 | 1.9 | C | B |
| 27 | EXAMPLE | a | B | 150.7 | 40.1 | 25.0 | 75.0 | 30.4 | 34.2 | 0.0 | 2.4 | B | C |
| 28 | EXAMPLE | a | B | 200.0 | 44.0 | 25.0 | 75.0 | 30.1 | 34.7 | 0.0 | 3.7 | B | C |
| 29 | EXAMPLE | a | C | 23.1 | 29.8 | 25.0 | 75.0 | 28.4 | 33.4 | 0.0 | 2.0 | B | C |
| 30 | EXAMPLE | a | C | 49.1 | 31.9 | 25.0 | 75.0 | 29.0 | 34.5 | 0.0 | 3.1 | B | C |
| 31 | EXAMPLE | a | C | 73.5 | 33.9 | 25.0 | 75.0 | 25.7 | 31.8 | 0.0 | 1.5 | B | B |
| 32 | EXAMPLE | a | C | 101.6 | 36.1 | 25.0 | 75.0 | 29.2 | 35.3 | 0.0 | 2.6 | C | B |
| 33 | EXAMPLE | a | C | 101.7 | 36.1 | 25.0 | 75.0 | 30.2 | 35.0 | 0.0 | 1.7 | B | B |
| 34 | EXAMPLE | a | C | 101.5 | 36.1 | 25.0 | 175.0 | 16.0 | 35.3 | 0.0 | 3.8 | B | B |
| 35 | EXAMPLE | a | C | 99.2 | 35.9 | 25.0 | 75.0 | 30.4 | 34.8 | 0.0 | 3.2 | C | B |
| 36 | EXAMPLE | a | C | 123.4 | 37.9 | 25.0 | 75.0 | 28.2 | 33.4 | 0.0 | 1.4 | B | B |
| 37 | EXAMPLE | a | C | 149.1 | 39.9 | 25.0 | 75.0 | 28.8 | 33.1 | 0.0 | 3.6 | B | B |
| 38 | EXAMPLE | a | C | 201.4 | 44.1 | 25.0 | 75.0 | 27.2 | 35.5 | 0.0 | 2.7 | B | C |
| 39 | EXAMPLE | a | D | 23.7 | 29.9 | 25.0 | 75.0 | 26.1 | 31.4 | 0.0 | 3.2 | B | C |
| 40 | EXAMPLE | a | D | 48.2 | 31.9 | 25.0 | 75.0 | 30.0 | 34.9 | 0.0 | 3.0 | B | C |
| 41 | EXAMPLE | a | D | 75.9 | 34.1 | 25.0 | 75.0 | 28.2 | 33.9 | 0.0 | 2.7 | B | B |
| 42 | EXAMPLE | a | D | 99.6 | 36.0 | 25.0 | 75.0 | 28.4 | 32.2 | 0.0 | 2.0 | C | B |

23

| No. | CATEGORY | COATED SUBSTRATE | ZINC-BASED COATINGS LAYER | | | SCRATCHING PROCESS CONDITION | | STEEL BASE EXPOSURE RATIO (%) | LONGEST ONE OF THE SHORTEST DISTANCES (μm) | TOTAL OF AREAS WHERE STEEL BASE EXPOSURE RATIO IS GREATER THAN 40.0% (%) | RATIO OF STEEL BASE EXPOSED PORTION IN SOIL (%) | CORROSION RESISTANCE EVALUATION | |
|---|---|---|---|---|---|---|---|---|---|---|---|---|---|
| | | | COATINGS TYPE | COATINGS WEIGHT (g/m²) | FORMULA(1) RIGHT SIDE | BLADE WIDTH (μm) | INTERVAL (μm) | | | | | IN GENERAL SOIL | IN ACID SOIL |
| 43 | EXAMPLE | a | D | 99.7 | 36.0 | 25.0 | 75.0 | 27.5 | 32.8 | 0.0 | 3.0 | B | B |
| 44 | EXAMPLE | a | D | 98.5 | 35.9 | 25.0 | 175.0 | 13.8 | 33.0 | 0.0 | 2.6 | B | B |
| 45 | EXAMPLE | a | D | 99.3 | 35.9 | 25.0 | 75.0 | 30.2 | 33.8 | 0.0 | 1.8 | C | B |
| 46 | EXAMPLE | a | D | 124.8 | 38.0 | 25.0 | 75.0 | 28.0 | 33.5 | 0.0 | 3.1 | B | B |
| 47 | EXAMPLE | a | D | 148.4 | 39.9 | 25.0 | 75.0 | 27.6 | 32.2 | 0.0 | 2.5 | B | B |
| 48 | EXAMPLE | a | D | 200.0 | 44.0 | 25.0 | 75.0 | 25.6 | 32.3 | 0.0 | 3.9 | B | C |
| 49 | EXAMPLE | a | E | 26.2 | 30.1 | 25.0 | 75.0 | 26.4 | 34.0 | 0.0 | 3.5 | B | B |
| 50 | EXAMPLE | a | E | 49.4 | 32.0 | 25.0 | 75.0 | 27.2 | 32.2 | 0.0 | 1.9 | B | B |

EP 4 772 673 A1

[Table 3-2]

TABLE 3-2

| No. | CATEGORY | COATED SUBSTRATE | ZINC-BASED COATINGS LAYER | | | SCRATCHING PROCESS CONDITION | | STEEL BASE EXPOSURE RATIO (%) | LONGEST ONE OF THE SHORTEST DISTANCES (μm) | TOTAL OF AREAS WHERE STEEL BASE EXPOSURE RATIO IS GREATER THAN 40.0% (%) | RATIO OF STEEL BASE EXPOSED PORTION IN SOIL (%) | CORROSION RESISTANCE EVALUATION | |
|---|---|---|---|---|---|---|---|---|---|---|---|---|---|
| | | | COATINGS TYPE | COATINGS WEIGHT (g/m$^2$) | FORMULA (1) RIGHT SIDE | BLADE WIDTH (μm) | INTERVAL (μm) | | | | | IN GENERAL SOIL | IN ACID SOIL |
| 51 | EXAMPLE | a | E | 75.9 | 34.1 | 25.0 | 75.0 | 26.0 | 30.9 | 0.0 | 2.9 | B | B |
| 52 | EXAMPLE | a | E | 100.7 | 36.1 | 25.0 | 75.0 | 27.4 | 34.1 | 0.0 | 3.3 | B | B |
| 53 | EXAMPLE | a | E | 98.0 | 35.8 | 25.0 | 75.0 | 28.7 | 34.0 | 0.0 | 3.5 | B | B |
| 54 | EXAMPLE | a | E | 101.4 | 36.1 | 25.0 | 175.0 | 15.8 | 34.1 | 0.0 | 2.3 | B | B |
| 55 | EXAMPLE | a | E | 99.1 | 35.9 | 25.0 | 75.0 | 29.0 | 32.8 | 0.0 | 1.9 | B | B |
| 56 | EXAMPLE | a | E | 123.4 | 37.9 | 25.0 | 75.0 | 29.8 | 33.8 | 0.0 | 2.0 | B | B |
| 57 | EXAMPLE | a | E | 151.2 | 40.1 | 25.0 | 75.0 | 26.8 | 32.0 | 0.0 | 3.4 | B | B |
| 58 | EXAMPLE | a | E | 199.3 | 43.9 | 25.0 | 75.0 | 26.5 | 32.1 | 0.0 | 2.5 | B | B |
| 59 | EXAMPLE | a | F | 25.0 | 30.0 | 25.0 | 75.0 | 25.5 | 32.0 | 0.0 | 1.3 | B | B |
| 60 | EXAMPLE | a | F | 49.0 | 31.9 | 25.0 | 75.0 | 27.6 | 34.0 | 0.0 | 2.9 | B | B |
| 61 | EXAMPLE | a | F | 75.9 | 34.1 | 25.0 | 75.0 | 31.5 | 35.6 | 0.0 | 3.9 | B | B |
| 62 | EXAMPLE | a | F | 99.8 | 36.0 | 25.0 | 75.0 | 29.6 | 34.6 | 0.0 | 2.1 | B | B |
| 63 | EXAMPLE | a | F | 100.7 | 36.1 | 25.0 | 75.0 | 27.7 | 35.2 | 0.0 | 2.0 | B | B |
| 64 | EXAMPLE | a | F | 99.5 | 36.0 | 25.0 | 175.0 | 11.9 | 30.9 | 0.0 | 3.8 | B | B |
| 65 | EXAMPLE | a | F | 100.3 | 36.0 | 25.0 | 75.0 | 28.9 | 35.7 | 0.0 | 3.7 | B | B |
| 66 | EXAMPLE | a | F | 125.7 | 38.1 | 25.0 | 75.0 | 26.3 | 32.7 | 0.0 | 2.4 | B | B |
| 67 | EXAMPLE | a | F | 149.5 | 40.0 | 25.0 | 75.0 | 24.8 | 31.5 | 0.0 | 3.4 | B | B |
| 68 | EXAMPLE | a | F | 201.3 | 44.1 | 25.0 | 75.0 | 28.3 | 31.5 | 0.0 | 4.0 | B | B |
| 69 | EXAMPLE | a | A | 98.5 | 35.9 | 25.0 | 75.0 | 30.0 | 32.9 | 0.0 | 7.0 | B | B |
| 70 | EXAMPLE | a | A | 126.1 | 38.1 | 25.0 | 75.0 | 29.4 | 33.8 | 0.0 | 13.0 | B | B |
| 71 | EXAMPLE | a | B | 76.8 | 34.1 | 25.0 | 75.0 | 29.1 | 34.5 | 0.0 | 27.0 | A | B |
| 72 | EXAMPLE | a | B | 125.9 | 38.1 | 25.0 | 75.0 | 26.8 | 32.4 | 0.0 | 90.0 | A | B |

| No. | CATEGORY | COATED SUBSTRATE | ZINC-BASED COATINGS LAYER | | | SCRATCHING PROCESS CONDITION | | STEEL BASE EXPOSURE RATIO (%) | LONGEST ONE OF THE SHORTEST DISTANCES (µm) | TOTAL OF AREAS WHERE STEEL BASE EXPOSURE RATIO IS GREATER THAN 40.0% (%) | RATIO OF STEEL BASE EXPOSED PORTION IN SOIL (%) | CORROSION RESISTANCE EVALUATION | |
|---|---|---|---|---|---|---|---|---|---|---|---|---|---|
| | | | COATINGS TYPE | COATINGS WEIGHT (g/m²) | FORMULA (1) RIGHT SIDE | BLADE WIDTH (µm) | INTERVAL (µm) | | | | | IN GENERAL SOIL | IN ACID SOIL |
| 73 | EXAMPLE | a | C | 98.9 | 35.9 | 25.0 | 75.0 | 29.2 | 33.2 | 0.0 | 100.0 | A | B |
| 74 | EXAMPLE | a | C | 125.1 | 38.0 | 25.0 | 75.0 | 29.8 | 35.2 | 0.0 | 80.0 | A | B |
| 75 | EXAMPLE | a | D | 76.8 | 34.1 | 25.0 | 75.0 | 28.7 | 32.7 | 0.0 | 15.0 | A | B |
| 76 | EXAMPLE | a | D | 74.8 | 34.0 | 25.0 | 75.0 | 26.7 | 33.4 | 0.0 | 9.0 | A | B |
| 77 | EXAMPLE | a | E | 126.3 | 38.1 | 25.0 | 75.0 | 26.1 | 31.5 | 0.0 | 15.0 | A | A |
| 78 | EXAMPLE | a | E | 73.3 | 33.9 | 25.0 | 75.0 | 29.3 | 31.2 | 0.0 | 18.0 | A | A |
| 79 | EXAMPLE | a | F | 123.7 | 37.9 | 25.0 | 75.0 | 29.1 | 33.5 | 0.0 | 85.0 | A | A |
| 80 | EXAMPLE | a | F | 126.8 | 38.1 | 25.0 | 75.0 | 29.2 | 33.0 | 0.0 | 25.0 | A | A |
| 81 | COMPARATIVE EXAMPLE | a | A | 24.3 | 29.9 | 0.0 | 0.0 | 0.0 | 0.0 | 0.0 | 3.7 | E | E |
| 82 | COMPARATIVE EXAMPLE | a | A | 48.7 | 31.9 | 0.0 | 0.0 | 0.0 | 0.0 | 0.0 | 2.8 | E | E |
| 83 | COMPARATIVE EXAMPLE | a | A | 73.2 | 33.9 | 0.0 | 0.0 | 0.0 | 0.0 | 0.0 | 1.7 | E | E |
| 84 | COMPARATIVE EXAMPLE | a | A | 99.3 | 35.9 | 0.0 | 0.0 | 0.0 | 0.0 | 0.0 | 1.7 | E | E |
| 85 | COMPARATIVE EXAMPLE | a | A | 124.1 | 37.9 | 0.0 | 0.0 | 0.0 | 0.0 | 0.0 | 1.5 | E | E |
| 86 | COMPARATIVE EXAMPLE | a | A | 151.4 | 40.1 | 0.0 | 0.0 | 0.0 | 0.0 | 0.0 | 1.3 | E | E |
| 87 | COMPARATIVE EXAMPLE | a | A | 173.0 | 41.8 | 0.0 | 0.0 | 0.0 | 0.0 | 0.0 | 2.2 | E | E |
| 88 | COMPARATIVE EXAMPLE | a | A | 198.9 | 43.9 | 0.0 | 0.0 | 0.0 | 0.0 | 0.0 | 3.1 | E | E |

(continued)

| No. | CATEGORY | COATED SUBSTRATE | ZINC-BASED COATINGS LAYER | | | SCRATCHING PROCESS CONDITION | | STEEL BASE EXPOSURE RATIO (%) | LONGEST ONE OF THE SHORTEST DISTANCES (μm) | TOTAL OF AREAS WHERE STEEL BASE EXPOSURE RATIO IS GREATER THAN 40.0% (%) | RATIO OF STEEL BASE EXPOSED PORTION IN SOIL (%) | CORROSION RESISTANCE EVALUATION | |
|---|---|---|---|---|---|---|---|---|---|---|---|---|---|
| | | | COATINGS TYPE | COATINGS WEIGHT (g/m²) | FORMULA (1) RIGHT SIDE | BLADE WIDTH (μm) | INTERVAL (μm) | | | | | IN GENERAL SOIL | IN ACID SOIL |
| 89 | COMPARATIVE EXAMPLE | a | B | 76.9 | 34.2 | 0.0 | 0.0 | 0.0 | 0.0 | 0.0 | 2.6 | D | E |
| 90 | COMPARATIVE EXAMPLE | a | C | 125.2 | 38.0 | 0.0 | 0.0 | 0.0 | 0.0 | 0.0 | 2.7 | D | E |
| 91 | COMPARATIVE EXAMPLE | a | D | 75.1 | 34.0 | 0.0 | 0.0 | 0.0 | 0.0 | 0.0 | 3.8 | D | D |
| 92 | COMPARATIVE EXAMPLE | a | E | 98.2 | 35.9 | 0.0 | 0.0 | 0.0 | 0.0 | 0.0 | 1.5 | D | D |
| 93 | COMPARATIVE EXAMPLE | a | F | 99.0 | 35.9 | 0.0 | 0.0 | 0.0 | 0.0 | 0.0 | 3.5 | D | D |
| 94 | COMPARATIVE EXAMPLE | a | A | 23.0 | 29.8 | 50.0 | 150.0 | 26.3 | 57.0 | 0.0 | 3.0 | E | E |
| 95 | COMPARATIVE EXAMPLE | a | A | 48.3 | 31.9 | 50.0 | 150.0 | 27.2 | 59.8 | 0.0 | 2.7 | E | E |
| 96 | COMPARATIVE EXAMPLE | a | A | 74.0 | 33.9 | 50.0 | 150.0 | 25.0 | 58.6 | 0.0 | 2.5 | E | E |
| 97 | COMPARATIVE EXAMPLE | a | A | 98.5 | 35.9 | 50.0 | 150.0 | 23.1 | 56.4 | 0.0 | 3.0 | E | E |
| 98 | COMPARATIVE EXAMPLE | a | A | 124.9 | 38.0 | 50.0 | 150.0 | 27.7 | 59.6 | 0.0 | 3.6 | E | E |
| 99 | COMPARATIVE EXAMPLE | a | A | 149.9 | 40.0 | 50.0 | 150.0 | 24.6 | 57.0 | 0.0 | 2.0 | E | E |
| 100 | COMPARATIVE EXAMPLE | a | A | 176.8 | 42.1 | 50.0 | 150.0 | 24.4 | 58.0 | 0.0 | 3.4 | E | E |

[Table 3-3]

[Table 3-3]

TABLE 3-3

| No. | CATEGORY | COATED SUBSTRATE | ZINC-BASED COATINGS LAYER | | | SCRATCHING PROCESS CONDITION | | STEEL BASE EXPOSURE RATIO (%) | LONGEST ONE OF THE SHORTEST DISTANCES (μm) | TOTAL OF AREAS WHERE STEEL BASE EXPOSURE RATIO IS GREATER THAN 40.0% (%) | RATIO OF STEEL BASE PORTION IN SOIL (%) | CORROSION RESISTANCE EVALUATION | |
|---|---|---|---|---|---|---|---|---|---|---|---|---|---|
| | | | COATINGS TYPE | COATINGS WEIGHT (g/m²) | FORMULA (1) RIGHT SIDE | BLADE WIDTH (μm) | INTERVAL (μm) | | | | | IN GENERAL SOIL | IN ACD SOIL |
| 101 | COMPARATIVE EXAMPLE | a | A | 199.7 | 44.0 | 50.0 | 150.0 | 26.8 | 59.7 | 0.0 | 2.5 | E | E |
| 102 | COMPARATIVE EXAMPLE | a | B | 48.1 | 31.8 | 50.0 | 150.0 | 23.8 | 56.0 | 0.0 | 3.1 | D | E |
| 103 | COMPARATIVE EXAMPLE | a | C | 75.3 | 34.0 | 50.0 | 150.0 | 26.7 | 57.2 | 0.0 | 2.4 | D | E |
| 104 | COMPARATIVE EXAMPLE | a | D | 77.0 | 34.2 | 50.0 | 150.0 | 28.2 | 58.8 | 0.0 | 1.6 | D | D |
| 105 | COMPARATIVE EXAMPLE | a | E | 151.1 | 40.1 | 50.0 | 150.0 | 23.9 | 57.3 | 0.0 | 2.5 | D | D |
| 106 | COMPARATIVE EXAMPLE | a | F | 98.8 | 35.9 | 50.0 | 150.0 | 25.3 | 60.7 | 0.0 | 2.3 | D | D |
| 107 | EXAMPLE COMPARATIVE | a | A | 24.6 | 30.0 | 25.0 | 25.0 | 55.4 | 31.9 | 100.0 | 1.4 | E | E |
| 108 | COMPARATIVE EXAMPLE | a | A | 49.9 | 32.0 | 25.0 | 250 | 55.6 | 35.3 | 100.0 | 3.5 | E | E |
| 109 | COMPARATIVE EXAMPLE | a | A | 75.1 | 34.0 | 25.0 | 250 | 55.8 | 32.4 | 100.0 | 1.7 | E | E |
| 110 | COMPARATIVE EXAMPLE | a | A | 102.0 | 36.2 | 25.0 | 25.0 | 55.9 | 34.6 | 100.0 | 2.8 | E | E |
| 111 | COMPARATIVE EXAMPLE | a | A | 124.2 | 37.9 | 25.0 | 25.0 | 51.3 | 31.4 | 100.0 | 2.1 | E | E |
| 112 | COMPARATIVE EXAMPLE | a | A | 152.0 | 40.2 | 25.0 | 25.0 | 52.0 | 33.0 | 100.0 | 2.1 | E | E |

| No. | CATEGORY | COATED SUBSTRATE | ZINC-BASED COATINGS LAYER | | | SCRATCHING PROCESS CONDITION | | STEEL BASE EXPOSURE RATIO (%) | LONGEST ONE OF THE SHORTEST DISTANCES ($\mu$m) | TOTAL OF AREAS WHERE STEEL BASE EXPOSURE RATIO IS GREATER THAN 40.0% (%) | RATIO OF STEEL BASE PORTION IN SOIL (%) | CORROSION RESISTANCE EVALUATION | |
|---|---|---|---|---|---|---|---|---|---|---|---|---|---|
| | | | COATINGS TYPE | COATINGS WEIGHT (g/m$^2$) | FORMULA (1) RIGHT SIDE | BLADE WIDTH ($\mu$m) | INTERVAL ($\mu$m) | | | | | IN GENERAL SOIL | IN ACD SOIL |
| 113 | COMPARATIVE EXAMPLE | a | A | 175.3 | 42.0 | 25.0 | 25.0 | 53.3 | 34.0 | 100.0 | 1.2 | E | E |
| 114 | COMPARATIVE EXAMPLE | a | A | 200.1 | 44.0 | 25.0 | 25.0 | 53.2 | 31.2 | 100.0 | 3.4 | E | E |
| 115 | COMPARATIVE EXAMPLE | a | B | 73.7 | 33.9 | 25.0 | 25.0 | 57.3 | 33.7 | 100.0 | 1.9 | E | E |
| 116 | COMPARATIVE EXAMPLE | a | C | 125.8 | 38.1 | 25.0 | 25.0 | 54.4 | 35.8 | 100.0 | 4.0 | E | E |
| 117 | COMPARATIVE EXAMPLE | a | D | 76.8 | 34.1 | 25.0 | 25.0 | 53.5 | 34.5 | 100.0 | 3.9 | E | D |
| 118 | COMPARATIVE EXAMPLE | a | E | 100.6 | 36.0 | 25.0 | 25.0 | 54.1 | 34.0 | 100.0 | 2.6 | E | D |
| 119 | COMPARATIVE EXAMPLE | a | F | 100.7 | 36.1 | 25.0 | 25.0 | 52.6 | 32.3 | 100.0 | 1.2 | E | D |
| 120 | COMPARATIVE EXAMPLE | a | A | 24.4 | 30.0 | 50.0 | 50.0 | 54.1 | 60.7 | 100.0 | 3.1 | E | E |
| 121 | COMPARATIVE EXAMPLE | a | A | 51.8 | 32.1 | 50.0 | 50.0 | 49.7 | 55.9 | 100.0 | 2.1 | E | E |
| 122 | COMPARATIVE EXAMPLE | a | A | 73.3 | 33.9 | 50.0 | 50.0 | 50.0 | 58.0 | 100.0 | 1.4 | E | E |
| 123 | COMPARATIVE EXAMPLE | a | A | 98.8 | 35.9 | 50.0 | 50.0 | 52.8 | 59.8 | 100.0 | 3.3 | E | E |
| 124 | COMPARATIVE EXAMPLE | a | A | 125.1 | 38.0 | 50.0 | 50.0 | 57.0 | 60.9 | 100.0 | 1.9 | E | E |

| No. | CATEGORY | COATED SUBSTRATE | ZINC-BASED COATINGS LAYER | | | SCRATCHING PROCESS CONDITION | | STEEL BASE EXPOSURE RATIO (%) | LONGEST ONE OF THE SHORTEST DISTANCES (μm) | TOTAL OF AREAS WHERE STEEL BASE EXPOSURE RATIO IS GREATER THAN 40.0% (%) | RATIO OF STEEL BASE PORTION IN SOIL (%) | CORROSION RESISTANCE EVALUATION | |
|---|---|---|---|---|---|---|---|---|---|---|---|---|---|
| | | | COATINGS TYPE | COATINGS WEIGHT (g/m²) | FORMULA (1) RIGHT SIDE | BLADE WIDTH (μm) | INTERVAL (μm) | | | | | IN GENERAL SOIL | IN ACD SOIL |
| 125 | COMPARATIVE EXAMPLE | a | A | 148.3 | 39.9 | 50.0 | 50.0 | 52.7 | 56.4 | 100.0 | 1.3 | E | E |
| 126 | COMPARATIVE EXAMPLE | a | A | 176.0 | 42.1 | 50.0 | 50.0 | 53.9 | 59.5 | 100.0 | 1.4 | E | E |
| 127 | COMPARATIVE EXAMPLE | a | A | 198.9 | 43.9 | 50.0 | 50.0 | 54.1 | 60.7 | 100.0 | 1.6 | E | E |
| 128 | COMPARATIVE EXAMPLE | a | B | 73.6 | 33.9 | 50.0 | 50.0 | 50.9 | 59.9 | 100.0 | 3.7 | E | E |
| 129 | COMPARATIVE EXAMPLE | a | C | 123.2 | 37.9 | 50.0 | 50.0 | 53.4 | 59.2 | 100.0 | 3.9 | E | E |
| 130 | COMPARATIVE EXAMPLE | a | D | 75.5 | 34.0 | 50.0 | 50.0 | 52.9 | 58.1 | 100.0 | 1.1 | E | D |
| 131 | COMPARATIVE EXAMPLE | a | E | 99.0 | 35.9 | 50.0 | 50.0 | 53.3 | 57.5 | 100.0 | 2.7 | E | D |
| 132 | COMPARATIVE EXAMPLE | a | F | 101.3 | 36.1 | 50.0 | 50.0 | 51.5 | 56.6 | 100.0 | 3.1 | E | D |
| 133 | EXAMPLE | b | A | 24.0 | 29.9 | 25.0 | 75.0 | 28.9 | 33.7 | 0.0 | 2.4 | C | C |
| 134 | EXAMPLE | c | B | 49.8 | 32.0 | 25.0 | 75.0 | 24.7 | 31.3 | 0.0 | 1.5 | B | C |
| 135 | EXAMPLE | b | C | 49.1 | 31.9 | 25.0 | 175.0 | 12.2 | 33.8 | 0.0 | 1.4 | B | C |
| 136 | EXAMPLE | c | D | 50.0 | 37.0 | 25.0 | 75.0 | 30.0 | 32.8 | 0.0 | 2.0 | B | B |
| 137 | EXAMPLE | b | E | 75.0 | 34.0 | 25.0 | 75.0 | 28.8 | 32.7 | 0.0 | 2.4 | B | B |
| 138 | EXAMPLE | c | F | 99.9 | 36.0 | 25.0 | 175.0 | 16.3 | 34.4 | 0.0 | 1.8 | B | B |
| 139 | EXAMPLE | b | A | 100.0 | 36.0 | 25.0 | 75.0 | 29.1 | 32.5 | 0.0 | 2.5 | C | C |
| 140 | EXAMPLE | c | B | 98.9 | 35.9 | 25.0 | 75.0 | 27.4 | 33.4 | 0.0 | 1.4 | B | B |

| No. | CATEGORY | COATED SUBSTRATE | ZINC-BASED COATINGS LAYER | | | SCRATCHING PROCESS CONDITION | | STEEL BASE EXPOSURE RATIO (%) | LONGEST ONE OF THE SHORTEST DISTANCES ($\mu$m) | TOTAL OF AREAS WHERE STEEL BASE EXPOSURE RATIO IS GREATER THAN 40.0% (%) | RATIO OF STEEL BASE PORTION IN SOIL (%) | CORROSION RESISTANCE EVALUATION | |
|---|---|---|---|---|---|---|---|---|---|---|---|---|---|
| | | | COATINGS TYPE | COATINGS WEIGHT (g/m$^2$) | FORMULA (1) RIGHT SIDE | BLADE WIDTH ($\mu$m) | INTERVAL ($\mu$m) | | | | | IN GENERAL SOIL | IN ACD SOIL |
| 141 | EXAMPLE | b | C | 127.0 | 38.2 | 25.0 | 175.0 | 12.5 | 33.1 | 0.0 | 1.8 | B | B |
| 142 | EXAMPLE | c | D | 150.7 | 40.1 | 25.0 | 75.0 | 28.8 | 31.4 | 0.0 | 7.0 | B | B |
| 143 | EXAMPLE | b | E | 150.9 | 40.1 | 25.0 | 75.0 | 31.3 | 35.6 | 0.0 | 15.0 | A | B |
| 144 | EXAMPLE | c | F | 151.1 | 40.1 | 25.0 | 175.0 | 149 | 32.5 | 0.0 | 23.0 | A | B |
| 145 | EXAMPLE | b | A | 176.4 | 42.1 | 25.0 | 75.0 | 28.9 | 30.9 | 0.0 | 85.0 | B | C |
| 146 | EXAMPLE | c | B | 201.0 | 44.1 | 25.0 | 75.0 | 29.0 | 34.4 | 0.0 | 100.0 | B | B |
| 147 | COMPARATIVE EXAMPLE | b | C | 49.7 | 32.0 | 0.0 | 0.0 | 0.0 | 0.0 | 0.0 | 3.5 | E | E |
| 148 | COMPARATIVE EXAMPLE | c | D | 100.9 | 36.1 | 50.0 | 150.0 | 25.1 | 56.5 | 0.0 | 3.2 | D | D |
| 149 | COMPARATIVE EXAMPLE | b | A | 150.7 | 40.1 | 25.0 | 25.0 | 53.1 | 33.2 | 100.0 | 1.5 | E | E |
| 150 | COMPARATIVE EXAMPLE | c | B | 198.2 | 43.9 | 50.0 | 50.0 | 49.6 | 57.5 | 100.0 | 1.8 | E | D |

[Table 4-1]

[Table 4-1]

TABLE 4-1

| No. | CATEGORY | COATED SUBSTRATE | ZINC-BASED COATINGS LAYER | | | BENDING PROCESS CONDITION | | STEEL BASE EXPOSURE RATIO (%) | LONGEST ONE OF THE SHORTEST DISTANCES ($\mu$m) | TOTAL OF AREAS WHERE STEEL BASE EXPOSURE RATIO IS GREATER THAN 40.0% (%) | RATIO OF STEEL BASE EXPOSED PORTION IN SOIL (%) | CORROSION RESISTANCE EVALUATION | |
|---|---|---|---|---|---|---|---|---|---|---|---|---|---|
| | | | COATINGS TYPE | COATINGS WEIGHT (g/m$^2$) | FORMULA (1) RIGHT SIDE | t/R | V (cm/s) | | | | | IN GENERAL SOIL | IN ACID SOIL |
| 151 | EXAMPLE | a | A | 26.8 | 30.1 | 1.0 | 0.1 | 5.0 | 4.0 | 3.7 | 3.7 | C | C |
| 152 | EXAMPLE | a | A | 50.7 | 32.1 | 0.9 | 0.2 | 3.0 | 33.0 | 4.7 | 1.9 | C | C |
| 153 | EXAMPLE | a | A | 51.9 | 32.2 | 1.7 | 0.2 | 13.0 | 12.0 | 4.8 | 1.9 | C | C |
| 154 | EXAMPLE | a | A | 48.7 | 31.9 | 2.9 | 0.1 | 27.0 | 14.0 | 4.7 | 2.5 | C | C |
| 155 | EXAMPLE | a | A | 49.9 | 32.0 | 3.9 | 0.2 | 39.0 | 31.0 | 4.5 | 2.8 | C | C |
| 156 | EXAMPLE | a | A | 76.2 | 34.1 | 1.6 | 0.2 | 12.0 | 5.0 | 2.5 | 3.8 | C | C |
| 157 | EXAMPLE | a | A | 101.5 | 36.1 | 0.9 | 0.1 | 3.0 | 20.0 | 3.7 | 1.3 | C | C |
| 158 | EXAMPLE | a | A | 98.2 | 35.9 | 2.0 | 0.1 | 17.0 | 10.0 | 3.3 | 2.6 | C | C |
| 159 | EXAMPLE | a | A | 98.1 | 35.8 | 2.3 | 0.2 | 20.0 | 49.0 | 2.9 | 2.2 | C | C |
| 160 | EXAMPLE | a | A | 99.7 | 36.0 | 3.7 | 0.1 | 37.0 | 35.0 | 4.5 | 1.5 | C | C |
| 161 | EXAMPLE | a | A | 123.1 | 37.8 | 0.9 | 0.2 | 3.0 | 49.0 | 3.1 | 3.6 | C | C |
| 162 | EXAMPLE | a | A | 150.7 | 40.1 | 0.8 | 0.2 | 2.0 | 49.0 | 3.6 | 3.8 | C | C |
| 163 | EXAMPLE | a | A | 152.0 | 40.2 | 1.9 | 0.3 | 15.0 | 50.0 | 2.7 | 2.7 | C | C |
| 164 | EXAMPLE | a | A | 151.6 | 40.1 | 2.1 | 0.2 | 18.0 | 45.0 | 2.9 | 3.2 | C | C |
| 165 | EXAMPLE | a | A | 149.7 | 40.0 | 3.4 | 0.1 | 33.0 | 40.0 | 4.0 | 4.0 | C | C |
| 166 | EXAMPLE | a | A | 174.8 | 42.0 | 3.5 | 0.3 | 34.0 | 35.0 | 3.4 | 3.3 | C | C |
| 167 | EXAMPLE | a | A | 198.8 | 43.9 | 1.0 | 0.1 | 5.0 | 26.0 | 4.2 | 3.0 | C | C |
| 168 | EXAMPLE | a | A | 300.9 | 52.1 | 1.6 | 0.2 | 12.0 | 4.0 | 3.1 | 3.4 | C | C |
| 169 | EXAMPLE | a | B | 27.0 | 30.2 | 2.5 | 0.1 | 22.0 | 44.0 | 2.6 | 2.3 | B | C |
| 170 | EXAMPLE | a | B | 51.0 | 32.1 | 2.0 | 0.2 | 17.0 | 7.0 | 4.1 | 3.5 | B | B |
| 171 | EXAMPLE | a | B | 74.2 | 33.9 | 1.4 | 0.1 | 9.0 | 38.0 | 3.5 | 2.8 | B | B |

(continued)

| No. | CATEGORY | COATED SUBSTRATE | ZINC-BASED COATINGS LAYER | | | BENDING PROCESS CONDITION | | STEEL BASE EXPOSURE RATIO (%) | LONGEST ONE OF THE SHORTEST DISTANCES (μm) | TOTAL OF AREAS WHERE STEEL BASE EXPOSURE RATIO IS GREATER THAN 40.0% (%) | RATIO OF STEEL BASE EXPOSED PORTION IN SOIL (%) | CORROSION RESISTANCE EVALUATION | |
| --- | --- | --- | --- | --- | --- | --- | --- | --- | --- | --- | --- | --- | --- |
| | | | COATINGS TYPE | COATINGS WEIGHT (g/m$^2$) | FORMULA (1) RIGHT SIDE | t/R | V (cm/s) | | | | | IN GENERAL SOIL | IN ACID SOIL |
| 172 | EXAMPLE | | B | 98.1 | 35.8 | 0.9 | 0.1 | 3.0 | 17.0 | 3.9 | 3.3 | C | C |
| 173 | EXAMPLE | a | B | 98.0 | 35.8 | 1.9 | 0.3 | 15.0 | 18.0 | 2.4 | 2.8 | B | B |
| 174 | EXAMPLE | a | B | 99.5 | 36.0 | 2.3 | 0.2 | 20.0 | 20.0 | 2.6 | 1.7 | B | B |
| 175 | EXAMPLE | a | B | 100.0 | 36.0 | 3.8 | 0.2 | 38.0 | 36.0 | 4.1 | 3.3 | C | C |
| 176 | EXAMPLE | a | B | 126.3 | 38.1 | 0.8 | 0.3 | 2.0 | 26.0 | 2.2 | 3.7 | C | C |
| 177 | EXAMPLE | a | B | 150.3 | 40.0 | 3.4 | 0.2 | 33.0 | 40.0 | 4.0 | 1.7 | B | C |
| 178 | EXAMPLE | a | B | 198.1 | 43.8 | 3.2 | 0.3 | 30.0 | 40.0 | 4.5 | 2.4 | B | C |
| 179 | EXAMPLE | a | C | 23.2 | 29.9 | 3.1 | 0.3 | 29.0 | 7.0 | 3.4 | 1.3 | B | C |
| 180 | EXAMPLE | a | C | 52.0 | 32.2 | 1.8 | 0.3 | 14.0 | 9.0 | 3.6 | 3.6 | B | B |
| 181 | EXAMPLE | a | C | 76.0 | 34.1 | 3.2 | 0.2 | 30.0 | 30.0 | 3.3 | 3.3 | B | B |
| 182 | EXAMPLE | a | C | 100.2 | 36.0 | 0.8 | 0.3 | 2.0 | 21.0 | 3.6 | 2.2 | C | C |
| 183 | EXAMPLE | a | C | 98.1 | 35.8 | 1.9 | 0.1 | 15.0 | 9.0 | 4.6 | 1.3 | B | B |
| 184 | EXAMPLE | a | C | 100.3 | 36.0 | 2.9 | 0.2 | 27.0 | 24.0 | 3.6 | 3.3 | B | B |
| 185 | EXAMPLE | a | C | 101.2 | 36.1 | 4.0 | 0.3 | 40.0 | 30.0 | 2.9 | 2.7 | C | C |
| 186 | EXAMPLE | a | C | 123.4 | 37.9 | 1.4 | 0.1 | 9.0 | 27.0 | 4.6 | 2.6 | B | B |
| 187 | EXAMPLE | a | C | 150.5 | 40.0 | 1.2 | 0.1 | 7.0 | 41.0 | 4.4 | 2.5 | B | C |
| 188 | EXAMPLE | a | C | 198.8 | 43.9 | 2.6 | 0.3 | 23.0 | 14.0 | 2.6 | 2.2 | B | C |
| 189 | EXAMPLE | a | D | 26.5 | 30.1 | 2.0 | 0.2 | 16.0 | 33.0 | 4.6 | 2.3 | B | C |
| 190 | EXAMPLE | a | D | 49.7 | 32.0 | 1.4 | 0.3 | 9.0 | 33.0 | 4.6 | 2.4 | B | C |
| 191 | EXAMPLE | a | D | 75.4 | 34.0 | 1.4 | 0.3 | 9.0 | 33.0 | 2.1 | 1.8 | B | B |
| 192 | EXAMPLE | a | D | 100.7 | 36.1 | 0.7 | 0.2 | 1.0 | 8.0 | 2.2 | 1.3 | C | C |

(continued)

| No. | CATEGORY | COATED SUBSTRATE | ZINC-BASED COATINGS LAYER | | | BENDING PROCESS CONDITION | | STEEL BASE EXPOSURE RATIO (%) | LONGEST ONE OF THE SHORTEST DISTANCES (µm) | TOTAL OF AREAS WHERE STEEL BASE EXPOSURE RATIO IS GREATER THAN 40.0% (%) | RATIO OF STEEL BASE EXPOSED PORTION IN SOIL (%) | CORROSION RESISTANCE EVALUATION | |
|---|---|---|---|---|---|---|---|---|---|---|---|---|---|
| | | | COATINGS TYPE | COATINGS WEIGHT (g/m$^2$) | FORMULA (1) RIGHT SIDE | t/R | V (cm/s) | | | | | IN GENERAL SOIL | IN ACID SOIL |
| 193 | EXAMPLE | a | D | 98.5 | 35.9 | 1.9 | 0.1 | 15.0 | 42.0 | 2.0 | 3.8 | B | B |
| 194 | EXAMPLE | a | D | 100.0 | 36.0 | 2.1 | 0.2 | 18.0 | 8.0 | 2.1 | 3.3 | B | B |
| 195 | EXAMPLE | a | D | 99.0 | 35.9 | 3.9 | 0.2 | 39.0 | 18.0 | 2.4 | 2.3 | C | C |
| 196 | EXAMPLE | a | D | 125.3 | 38.0 | 2.3 | 0.2 | 20.0 | 33.0 | 3.4 | 2.1 | B | B |
| 197 | EXAMPLE | a | D | 151.5 | 40.1 | 3.5 | 0.2 | 34.0 | 29.0 | 1.9 | 3.7 | B | C |
| 198 | EXAMPLE | a | D | 201.4 | 44.1 | 1.5 | 0.2 | 11.0 | 41.0 | 3.6 | 2.4 | B | C |
| 199 | EXAMPLE | a | E | 23.4 | 29.9 | 0.8 | 0.2 | 2.0 | 6.0 | 3.5 | 3.7 | B | C |
| 200 | EXAMPLE | a | E | 50.0 | 32.0 | 1.8 | 0.2 | 14.0 | 41.0 | 4.8 | 1.5 | B | B |

37

[Table 4-2]

TABLE 4-2

| No. | CATEGORY | COATED SUBSTRATE | ZINC-BASED COATINGS LAYER | | | BENDING PROCESS CONDITION | | STEEL BASE EXPOSURE RATIO (%) | LONGEST ONE OF THE SHORTEST DISTANCES ($\mu$m) | TOTAL OF AREAS WHERE STEEL BASE EXPOSURE RATIO IS GREATER THAN 40.0% (%) | RATIO OF STEEL BASE EXPOSED PORTION IN SOIL (%) | CORROSION RESISTANCE EVALUATION | |
|---|---|---|---|---|---|---|---|---|---|---|---|---|---|
| | | | COATINGS TYPE | COATINGS WEIGHT (g/m$^2$) | FORMULA (1) RIGHT SIDE | t/R | V (cm/s) | | | | | IN GENERAL SOIL | IN ACID SOIL |
| 201 | EXAMPLE | a | E | 73.4 | 33.9 | 0.9 | 0.2 | 4.0 | 16.0 | 4.5 | 3.8 | B | B |
| 202 | EXAMPLE | a | E | 101.9 | 36.2 | 0.8 | 0.1 | 2.0 | 11.0 | 2.1 | 2.3 | B | B |
| 203 | EXAMPLE | a | E | 101.9 | 36.2 | 1.6 | 0.1 | 12.0 | 49.0 | 2.8 | 2.2 | B | B |
| 204 | EXAMPLE | a | E | 99.0 | 35.9 | 2.5 | 0.3 | 22.0 | 45.0 | 2.0 | 2.2 | B | B |
| 205 | EXAMPLE | a | E | 98.5 | 35.9 | 3.9 | 0.2 | 39.0 | 20.0 | 3.9 | 3.0 | B | B |
| 206 | EXAMPLE | a | E | 123.1 | 37.8 | 3.8 | 0.1 | 38.0 | 17.0 | 4.3 | 3.5 | B | B |
| 207 | EXAMPLE | a | E | 148.4 | 39.9 | 2.3 | 0.2 | 20.0 | 16.0 | 4.0 | 1.4 | B | B |
| 208 | EXAMPLE | a | E | 201.5 | 44.1 | 1.1 | 0.3 | 6.0 | 3.0 | 4.8 | 3.0 | B | B |
| 209 | EXAMPLE | a | F | 24.8 | 30.0 | 3.3 | 0.2 | 32.0 | 18.0 | 3.4 | 2.3 | B | C |
| 210 | EXAMPLE | a | F | 50.2 | 32.0 | 3.8 | 0.2 | 38.0 | 38.0 | 4.5 | 1.9 | B | B |
| 211 | EXAMPLE | a | F | 76.0 | 34.1 | 1.8 | 0.2 | 14.0 | 26.0 | 3.1 | 3.5 | B | B |
| 212 | EXAMPLE | a | F | 98.7 | 35.9 | 0.7 | 0.2 | 1.0 | 22.0 | 3.3 | 1.3 | B | B |
| 213 | EXAMPLE | a | F | 99.6 | 36.0 | 1.3 | 0.1 | 8.0 | 8.0 | 4.1 | 1.8 | B | B |
| 214 | EXAMPLE | a | F | 101.3 | 36.1 | 1.6 | 0.2 | 12.0 | 49.0 | 2.9 | 2.1 | B | B |
| 215 | EXAMPLE | a | F | 99.2 | 35.9 | 3.8 | 0.3 | 38.0 | 46.0 | 4.5 | 3.6 | B | B |
| 216 | EXAMPLE | a | F | 124.8 | 38.0 | 2.0 | 0.2 | 17.0 | 24.0 | 4.6 | 3.3 | B | B |
| 217 | EXAMPLE | a | F | 149.7 | 40.0 | 1.1 | 0.1 | 6.0 | 36.0 | 4.0 | 3.4 | B | B |
| 218 | EXAMPLE | a | F | 200.1 | 44.0 | 3.2 | 0.3 | 30.0 | 24.0 | 4.2 | 3.1 | B | B |
| 219 | EXAMPLE | a | A | 98.7 | 35.9 | 2.7 | 0.3 | 25.0 | 22.0 | 3.9 | 5.0 | B | B |
| 220 | EXAMPLE | a | A | 124.4 | 38.0 | 2.6 | 0.3 | 24.0 | 11.0 | 3.5 | 18.0 | B | B |
| 221 | EXAMPLE | a | B | 74.6 | 34.0 | 3.1 | 0.3 | 29.0 | 19.0 | 3.1 | 25.0 | A | B |

(continued)

| No. | CATEGORY | COATED SUBSTRATE | ZINC-BASED COATINGS LAYER | | | BENDING PROCESS CONDITION | | STEEL BASE EXPOSURE RATIO (%) | LONGEST ONE OF THE SHORTEST DISTANCES (μm) | TOTAL OF AREAS WHERE STEEL BASE EXPOSURE RATIO IS GREATER THAN 40.0% (%) | RATIO OF STEEL BASE EXPOSED PORTION IN SOIL (%) | CORROSION RESISTANCE EVALUATION | |
|---|---|---|---|---|---|---|---|---|---|---|---|---|---|
| | | | COATINGS TYPE | COATINGS WEIGHT (g/m²) | FORMULA (1) RIGHT SIDE | t/R | V (cm/s) | | | | | IN GENERAL SOIL | IN ACID SOIL |
| 222 | EXAMPLE | a | B | 125.8 | 38.1 | 1.6 | 0.2 | 12.0 | 44.0 | 4.6 | 80.0 | A | B |
| 223 | EXAMPLE | a | C | 100.9 | 36.1 | 2.0 | 0.1 | 17.0 | 40.0 | 3.1 | 100.0 | A | B |
| 224 | EXAMPLE | a | C | 125.6 | 38.0 | 1.3 | 0.2 | 8.0 | 43.0 | 2.8 | 75.0 | A | B |
| 225 | EXAMPLE | a | D | 74.2 | 33.9 | 1.0 | 0.2 | 5.0 | 23.0 | 4.2 | 12.0 | A | B |
| 226 | EXAMPLE | a | D | 74.9 | 34.0 | 1.6 | 0.1 | 12.0 | 12.0 | 4.0 | 6.0 | A | B |
| 227 | EXAMPLE | a | E | 124.5 | 38.0 | 3.4 | 0.3 | 33.0 | 37.0 | 2.2 | 15.0 | A | A |
| 228 | EXAMPLE | a | E | 74.3 | 33.9 | 1.8 | 0.2 | 14.0 | 13.0 | 4.9 | 18.0 | A | A |
| 229 | EXAMPLE | a | F | 126.8 | 38.1 | 2.7 | 0.3 | 25.0 | 45.0 | 3.0 | 90.0 | A | A |
| 230 | EXAMPLE | a | F | 124.7 | 38.0 | 2.9 | 0.2 | 27.0 | 45.0 | 4.6 | 30.0 | A | A |
| 231 | COMPARATIVE EXAMPLE | a | A | 23.4 | 29.9 | 0.1 | 0.3 | 0.0 | 0.0 | 4.8 | 3.7 | E | E |
| 232 | COMPARATIVE EXAMPLE | a | A | 48.0 | 31.8 | 0.4 | 0.3 | 0.5 | 7.0 | 2.0 | 2.8 | E | C |
| 233 | COMPARATIVE EXAMPLE | a | A | 73.7 | 33.9 | 0.4 | 0.1 | 0.3 | 3.0 | 4.6 | 1.7 | E | C |
| 234 | COMPARATIVE EXAMPLE | a | A | 101.0 | 36.1 | 0.3 | 0.2 | 0.1 | 5.0 | 4.5 | 1.7 | E | C |
| 235 | COMPARATIVE EXAMPLE | a | A | 125.3 | 38.0 | 0.4 | 0.2 | 0.5 | 1.0 | 3.5 | 1.5 | E | C |
| 236 | COMPARATIVE EXAMPLE | a | A | 149.1 | 39.9 | 0.3 | 0.1 | 0.2 | 2.0 | 2.8 | 1.3 | E | C |
| 237 | COMPARATIVE EXAMPLE | a | A | 175.7 | 42.1 | 0.3 | 0.2 | 0.2 | 4.0 | 3.1 | 2.2 | E | D |

| No. | CATEGORY | COATED SUBSTRATE | ZINC-BASED COATINGS LAYER | | | BENDING PROCESS CONDITION | | STEEL BASE EXPOSURE RATIO (%) | LONGEST ONE OF THE SHORTEST DISTANCES ($\mu$m) | TOTAL OF AREAS WHERE STEEL BASE EXPOSURE RATIO IS GREATER THAN 40.0% (%) | RATIO OF STEEL BASE EXPOSED PORTION IN SOIL (%) | CORROSION RESISTANCE EVALUATION | |
|---|---|---|---|---|---|---|---|---|---|---|---|---|---|
| | | | COATINGS TYPE | COATINGS WEIGHT (g/m$^2$) | FORMULA (1) RIGHT SIDE | t/R | V (cm/s) | | | | | IN GENERAL SOIL | IN ACID SOIL |
| 238 | COMPARATIVE EXAMPLE | a | A | 199.8 | 44.0 | 0.4 | 0.2 | 0.4 | 3.0 | 3.8 | 3.1 | E | D |
| 239 | COMPARATIVE EXAMPLE | a | B | 74.2 | 33.9 | 0.4 | 0.2 | 0.3 | 5.0 | 2.3 | 2.6 | D | C |
| 240 | COMPARATIVE EXAMPLE | a | C | 126.3 | 38.1 | 0.4 | 0.2 | 0.4 | 1.0 | 3.0 | 2.7 | D | C |
| 241 | COMPARATIVE EXAMPLE | a | D | 75.3 | 34.0 | 0.3 | 0.1 | 0.2 | 2.0 | 2.0 | 3.8 | D | C |
| 242 | COMPPRATNE EXAMPLE | a | E | 98.7 | 35.9 | 0.3 | 0.2 | 0.1 | 3.0 | 3.2 | 1.5 | D | B |
| 243 | COMPARATIVE EXAMPLE | a | F | 98.2 | 35.9 | 0.3 | 0.2 | 0.0 | 0.0 | 4.5 | 3.5 | D | C |
| 244 | COMPARATIVE EXAMPLE | a | A | 25.4 | 30.0 | 3.8 | 16.7 | 38.0 | 66.0 | 4.1 | 3.0 | E | E |
| 245 | COMPARATIVE EXAMPLE | a | A | 49.0 | 31.9 | 0.9 | 16.9 | 4.0 | 101.0 | 3.6 | 2.7 | E | E |
| 246 | COMPARATIVE EXAMPLE | a | A | 76.0 | 34.1 | 2.8 | 15.3 | 26.0 | 96.0 | 4.2 | 2.5 | E | C |
| 247 | COMPARATIVE EXAMPLE | a | A | 100.8 | 36.1 | 3.4 | 17.6 | 33.0 | 82.0 | 2.5 | 3.0 | E | C |
| 248 | COMPARATIVE EXAMPLE | a | A | 125.9 | 36.1 | 1.6 | 15.2 | 12.0 | 89.0 | 4.6 | 36 | E | C |
| 249 | COMPARATIVE EXAMPLE | a | A | 151.0 | 40.1 | 2.6 | 17.3 | 23.0 | 84.0 | 1.9 | 2.0 | E | D |

| No. | CATEGORY | COATED SUBSTRATE | ZINC-BASED COATINGS LAYER | | | BENDING PROCESS CONDITION | | STEEL BASE EXPOSURE RATIO (%) | LONGEST ONE OF THE SHORTEST DISTANCES ($\mu$m) | TOTAL OF AREAS WHERE STEEL BASE EXPOSURE RATIO IS GREATER THAN 40.0% (%) | RATIO OF STEEL BASE EXPOSED PORTION IN SOIL (%) | CORROSION RESISTANCE EVALUATION | |
| | | | COATINGS TYPE | COATINGS WEIGHT (g/m$^2$) | FORMULA (1) RIGHT SIDE | t/R | V (cm/s) | | | | | IN GENERAL SOIL | IN ACID SOIL |
|---|---|---|---|---|---|---|---|---|---|---|---|---|---|
| 250 | COMPARATIVE EXAMPLE | a | A | 174.7 | 42.0 | 1.9 | 17.4 | 15.0 | 57.0 | 2.9 | 3.4 | E | D |

[Table 4-3]

TABLE 4-3

| No. | CATEGORY | COATED SUBSTRATE | ZINC-BASED COATINGS LAYER | | | BENDING PROCESS CONDITION | | STEEL BASE EXPOSURE RATIO (%) | LONGEST ONE OF THE SHORTEST DISTANCES (μm) | TOTAL OF AREAS WHERE STEEL BASE EXPOSURE THAN IS GREATER THAN 40.0% (%) | RATIO OF STEEL BASE EXPOSED PORTION IN SOIL (%) | CORROSION RESISTANCE EVALUATION | |
|---|---|---|---|---|---|---|---|---|---|---|---|---|---|
| | | | COATNGS TYPE | COATINGS WEIGHT (g/m²) | FORMULA (1) RIGHT SIDE | t/R | V (cm/s) | | | | | IN GENERAL SOIL | IN ACID SOIL |
| 251 | COMPARATIVE EXAMPLE | a | A | 200.9 | 44.1 | 1.1 | 18.1 | 6.0 | 56.0 | 4.4 | 2.5 | E | D |
| 252 | COMPARATIVE EXAMPLE | a | B | 48.8 | 31.9 | 2.5 | 18.4 | 22.0 | 69.0 | 3.5 | 3.1 | D | C |
| 253 | COMPARATIVE EXAMPLE | a | C | 76.1 | 34.1 | 2.2 | 17.4 | 19.0 | 76.0 | 3.2 | 2.4 | D | D |
| 254 | COMPARATIVE EXAMPLE | a | D | 73.6 | 33.9 | 4.0 | 17.0 | 40.0 | 67.0 | 3.9 | 1.6 | D | D |
| 255 | COMPARATIVE EXAMPLE | a | E | 150.1 | 40.0 | 3.9 | 19.2 | 39.0 | 88.0 | 4.6 | 2.5 | D | D |
| 256 | COMPARATIVE EXAMPLE | a | F | 100.6 | 36.0 | 2.4 | 19.9 | 21.0 | 59.0 | 4.8 | 2.3 | D | D |
| 257 | COMPARATIVE EXAMPLE | a | A | 26.8 | 30.1 | 5.6 | 0.2 | 59.0 | 28.0 | 21.9 | 1.4 | E | E |
| 258 | COMPARATIVE EXAMPLE | a | A | 48.4 | 31.9 | 5.0 | 0.3 | 52.0 | 18.0 | 23.2 | 3.5 | E | E |
| 259 | COMPARATIVE EXAMPLE | a | A | 75.8 | 34.1 | 5.7 | 0.2 | 60.0 | 16.0 | 11.7 | 1.7 | E | E |
| 260 | COMPARATIVE EXAMPLE | a | A | 101.3 | 36.1 | 5.5 | 0.2 | 58.0 | 18.0 | 6.0 | 2.8 | E | E |
| 261 | COMPARATIVE EXAMPLE | a | A | 124.2 | 37.9 | 4.5 | 0.2 | 46.0 | 36.0 | 9.2 | 2.1 | E | E |
| 262 | COMPARATIVE EXAMPLE | a | A | 148.1 | 39.8 | 5.9 | 0.3 | 62.0 | 11.0 | 15.7 | 2.1 | E | E |
| 263 | COMPARATIVE EXAMPLE | a | A | 176.9 | 42.2 | 5.9 | 0.2 | 62.0 | 22.0 | 17.9 | 1.2 | E | E |
| 264 | COMPARATIVE EXAMPLE | a | A | 199.0 | 43.9 | 5.4 | 0.2 | 57.0 | 20.0 | 10.7 | 3.4 | E | E |
| 265 | COMPARATIVE EXAMPLE | a | B | 74.6 | 34.0 | 5.0 | 0.2 | 52.0 | 15.0 | 21.2 | 1.9 | E | E |
| 266 | COMPPARATIVE EXAMPLE | a | C | 123.9 | 37.9 | 4.6 | 0.2 | 47.0 | 42.0 | 21.9 | 4.0 | E | E |
| 267 | COMPARATIVE EXAMPLE | a | D | 76.3 | 34.1 | 5.7 | 0.2 | 60.0 | 27.0 | 16.2 | 3.9 | E | D |
| 268 | COMPARATIVE EXAMPLE | a | E | 100.8 | 36.1 | 5.9 | 0.3 | 62.0 | 9.0 | 11.6 | 2.6 | E | D |
| 269 | COMPARATIVE EXAMPLE | a | F | 100.8 | 36.1 | 5.9 | 0.3 | 62.0 | 17.0 | 20.7 | 1.2 | E | D |
| 270 | COMPARATIVE EXAMPLE | a | A | 24.6 | 30.0 | 6.0 | 17.4 | 63.0 | 68.0 | 10.3 | 3.1 | E | E |
| 271 | COMPARATIVE EXAMPLE | a | A | 48.3 | 31.9 | 5.1 | 17.5 | 53.0 | 77.0 | 7.0 | 2.1 | E | E |

(continued)

| No. | CATEGORY | COATED SUBSTRATE | ZINC-BASED COATINGS LAYER | | | BENDING PROCESS CONDITION | | STEEL BASE EXPOSURE RATIO (%) | LONGEST ONE **OF THE** SHORTEST **DISTANCES** ($\mu$m) | TOTAL OF AREAS WHERE STEEL BASE EXPOSURE THAN IS GREATER THAN 40.0% (%) | RATIO OF STEEL BASE EXPOSED PORTION IN SOIL (%) | CORROSION RESISTANCE **EVALUATION** | |
|---|---|---|---|---|---|---|---|---|---|---|---|---|---|
| | | | COATNGS TYPE | COATINGS WEIGHT (g/m$^2$) | FORMULA (1) RIGHT SIDE | t/R | V (cm/s) | | | | | IN GENERAL SOIL | IN ACID SOIL |
| 272 | COMPARATIVE EXAMPLE | a | A | 73.8 | 33.9 | 6.1 | 17.4 | 65.0 | 73.0 | 12.9 | 1.4 | E | E |
| 273 | COMPARATIVE EXAMPLE | a | A | 100.3 | 36.0 | 5.6 | 19.0 | 59.0 | 61.0 | 21.7 | 3.3 | E | E |
| 274 | COMPARATIVE EXAMPLE | a | A | 124.8 | 38.0 | 5.3 | 18.8 | 55.0 | 58.0 | 20.3 | 1.9 | E | E |
| 275 | COMPARATIVE EXAMPLE | a | A | 151.9 | 40.2 | 6.1 | 17.3 | 65.0 | 57.0 | 11.1 | 1.3 | E | E |
| 276 | COMPARATIVE EXAMPLE | a | A | 176.2 | 42.1 | 4.7 | 19.5 | 48.0 | 92.0 | 17.2 | 1.4 | E | E |
| 277 | COMPARATIVE EXAMPLE | a | A | 198.7 | 43.9 | 5.1 | 17.6 | 53.0 | 67.0 | 20.6 | 1.6 | E | E |
| 278 | COMPARATIVE EXAMPLE | a | B | 76.6 | 34.1 | 6.0 | 17.8 | 63.0 | 104.0 | 19.9 | 3.7 | E | E |
| 279 | COMPARATIVE EXAMPLE | a | C | 126.4 | 38.1 | 5.1 | 17.8 | 53.0 | 68.0 | 16.1 | 3.9 | E | E |
| 280 | COMPARATIVE EXAMPLE | a | D | 73.9 | 33.9 | 5.2 | 17.9 | 54.0 | 85.0 | 20.8 | 1.1 | E | D |
| 281 | COMPARATIVE EXAMPLE | a | E | 99.8 | 36.0 | 4.6 | 17.5 | 47.0 | 70.0 | 13.3 | 2.7 | E | D |
| 282 | COMPARATIVE EXAMPLE | a | F | 99.3 | 35.9 | 5.1 | 17.7 | 53.0 | 99.0 | 11.0 | 3.1 | E | D |
| 283 | EXAMPLE | b | A | 23.6 | 29.9 | 0.9 | 0.2 | 3.0 | 4.0 | 2.0 | 1.9 | C | C |
| 284 | EXAMPLE | c | B | 50.9 | 32.1 | 2.6 | 0.1 | 23.0 | 20.0 | 3.9 | 1.7 | B | B |
| 285 | EXAMPLE | b | C | 50.4 | 32.0 | 1.9 | 0.2 | 15.0 | 23.0 | 4.4 | 1.3 | B | B |
| 286 | EXAMPLE | c | D | 49.4 | 32.0 | 2.1 | 0.2 | 18.0 | 5.0 | 4.6 | 2.4 | B | C |
| 287 | EXAMPLE | b | E | 75.9 | 34.1 | 2.3 | 0.2 | 200 | 19.0 | 2.1 | 2.3 | B | B |
| 288 | EXAMPLE | c | F | 98.6 | 35.9 | 2.6 | 0.1 | 23.0 | 18.0 | 3.0 | 3.7 | B | B |
| 289 | EXAMPLE | b | A | 99.2 | 35.9 | 3.8 | 0.2 | 38.0 | 39.0 | 2.2 | 1.3 | C | C |
| 290 | EXAMPLE | c | B | 101.8 | 36.1 | 3.1 | 0.2 | 29.0 | 20.0 | 4.7 | 1.5 | B | B |
| 291 | EXAMPLE | b | C | 125.6 | 38.0 | 2.7 | 0.3 | 25.0 | 49.0 | 2.4 | 2.1 | B | B |
| 292 | EXAMPLE | c | D | 148.4 | 39.9 | 2.4 | 0.3 | 21.0 | 14.0 | 4.2 | 7.0 | A | B |
| 293 | EXAMPLE | b | E | 148.5 | 39.9 | 1.5 | 0.2 | 11.0 | 18.0 | 3.7 | 18.0 | A | A |

(continued)

| No. | CATEGORY | COATED SUBSTRATE | ZINC-BASED COATINGS LAYER | | | BENDING PROCESS CONDITION | | STEEL BASE EXPOSURE RATIO (%) | LONGEST ONE **OF THE** SHORTEST **DISTANCES** ($\mu$m) | TOTAL OF AREAS WHERE STEEL BASE EXPOSURE THAN IS GREATER THAN 40.0% (%) | RATIO OF STEEL BASE EXPOSED PORTION IN SOIL (%) | CORROSION RESISTANCE **EVALUATION** | |
|---|---|---|---|---|---|---|---|---|---|---|---|---|---|
| | | | COATNGS TYPE | COATINGS WEIGHT (g/m$^2$) | FORMULA (1) RIGHT SIDE | t/R | V (cm/s) | | | | | IN GENERAL SOIL | IN ACID SOIL |
| 294 | EXAMPLE | c | F | 149.1 | 39.9 | 1.3 | 0.2 | 8.0 | 19.0 | 3.0 | 23.0 | A | A |
| 295 | EXAMPLE | b | A | 175.7 | 42.1 | 0.8 | 0.1 | 2.0 | 2.0 | 4.3 | 80.0 | C | C |
| 296 | EXAMPLE | c | B | 201.3 | 44.1 | 1.1 | 0.3 | 6.0 | 23.0 | 4.8 | 100.0 | B | B |
| 297 | COMPARATIVE EXAMPLE | b | C | 48.3 | 31.9 | 0.0 | 0.0 | 0.0 | 0.0 | 0.0 | 3.5 | E | E |
| 298 | COMPARATIVEEXAMPLE | c | D | 98.5 | 35.9 | 50.0 | 150.0 | 23.9 | 57.8 | 0.0 | 3.2 | D | D |
| 299 | COMPARATIVEEXAMPLE | b | A | 149.1 | 39.9 | 25.0 | 25.0 | 52.2 | 31.3 | 100.0 | 1.5 | E | E |
| 300 | COMPARATIVEEXAMPLE | c | B | 198.5 | 43.9 | 50.0 | 50.0 | 51.9 | 56.1 | 100.0 | 1.8 | E | D |

As is clear from Table 3-1 to Table 4-3 above, the surface-treated members corresponding to the example of the present invention exhibited excellent corrosion resistance even in the soil, whereas the surface-treated members corresponding to the comparative example of the present invention were unable to obtained sufficient corrosion resistance.

The preferred embodiment of the present invention has been described above in detail with reference to the attached drawings, but the present invention is not limited to the embodiment. It should be understood that various changes and modifications are readily apparent to those skilled in the art who have the common general knowledge in the technival field to which the present invention pertains, within the scope of the technical spirit as set forth in claims, and they should also be covered by the technical scope of the present invention.

The embodiment disclosed herein is examples in all respects and not restrictive. The above embodiment may be omitted, substituted, or modified in various forms without departing from the scope of the appended claims, the configurations within the technical scope of the invention as described below, and the main idea thereof. For example, constituent elements of the above-described embodiment may be arbitrarily combined to the extent that the effects thereof are not impaired. In addition, from such arbitrary combination, the action and effect for each of the constituent elements for the combination will naturally be obtained, as well as other actions and other effects that are obvious to those skilled in the art from the description herein.

Further, the effects described herein are merely explanatory or illustrative, and are not restrictive. In other words, the technique relating to the present invention can offer other effects that are obvious to those skilled in the art from the description herein in addition to or in place of the above effects.

Note that the following configurations also belong to the technical scope of the present invention.

(1) A surface-treated member being a surface-treated member formed of a surface-treated steel material including:

a steel material serving as a base material; and
zinc-based coatings layers located on surfaces of the steel material, in which
a steel base exposed portion, which is a portion where the surface of the steel material is exposed, is present in at least a portion of the zinc-based coatings layer,
in a case where a cross section obtained by cutting the steel base exposed portion in the thickness direction of the steel material according to the shape of the steel base exposed portion when the zinc-based coatings layer is viewed in plan from above is observed with a microscope, at least one or more cross sections each having a steel base exposure ratio, which is a ratio of a portion where the surface of the steel material is exposed in the cross section, falling within a range of 1.0 to 40.0% are present,
in the cross section having the steel base exposure ratio falling within a range of 1.0 to 40.0%, the shortest distance from any point on the surface of the exposed steel material to the zinc-based coatings layer is greater than 0 $\mu$m and 50.0 $\mu$m or less, and
for each of regions where a cross section having the steel base exposure ratio being greater than 40.0% is given, the total area of the regions when viewed in plan from above is 5.0% or less relative to the entire area of the steel base exposed portion.

(2) The surface-treated member according to (1), used by burying at least a portion of the steel base exposed portion in soil.
(3) The surface-treated member according to (2), in which

the steel base exposed portion is specified by performing a color identification test, which causes a color reaction at a portion where a steel base is exposed, over the entire surface of the zinc-based coatings layer,
in a case where each of the specified steel base exposed portions is viewed in plan from above the zinc-based coatings layer, each of the steel base exposed portions is virtually divided into rectangular regions each having a short side of 5 mm or more and an area of 1 cm$^2$ as a division, and for each of the divisions where the area ratio of the steel base exposed portion to the rectangular region is 3% or more, the cross section of each of the divisions is observed, and thereby the steel base exposure ratio is measured, and
the ratio of the total area of the divisions where the cross section having the steel base exposure ratio falling within a range of 1.0 to 40.0% is obtained to the area of a portion buried in the soil is 5.0% or more.

(4) The surface-treated member according to any one of (1) to (3), in which

the zinc-based coatings layer is a plating layer having a chemical composition containing, in mass%,
Al: 0.10% or more and less than 40.00%, and
Mg: 0.10% or more and less than 15.00%, with the balance consisting of Zn and impurities.

(5) The surface-treated member according to (4), in which

the zinc-based coatings layer is a coatings layer containing, in mass%,
Al: 0.10% or more and less than 40.00%,
Mg: 0.10% or more and less than 15.00%, and
Zn: 60.00% or more.

(6) The surface-treated member according to any one of (1) to (3), in which

the zinc-based coatings layer is a coatings layer having a chemical composition containing, in mass%,
Al: 0.10% or more and less than 40.00%,
Mg: 0.10% or more and less than 15.00%, and
further containing one or two or more selected from the group consisting of an element group A, an element group B, an element group C, an element group D, an element group E, and an element group F described below, with the balance consisting of Zn and impurities.

[Element group A]: one or two selected from the group consisting of Si: 2.50% or less and Fe: 5.00% or less
[Element group B]: one or two or more selected from the group consisting of Sb: less than 0.50%, Pb: less than 0.50%, and Sr: less than 0.50%
[Element group C]: one or two or more selected from the group consisting of Cu: less than 0.25%, Ti: less than 0.25%, Cr: less than 0.25%, Nb: less than 0.25%, Ni: less than 0.25%, Mn: less than 0.25%, Co: less than 0.25%, and V: less than 0.25%
[Element group D]: one or two or more selected from the group consisting of Sn: 20.00% or less, Bi: less than 5.00%, and In: less than 2.00%
[Element group E]: one or two or more selected from the group consisting of Ca: 3.00% or less, La: less than 0.50%, Ce: less than 0.50%, and Y: 0.50% or less
[Element group F]: B: less than 0.50%

(7) The surface-treated member according to (6), in which
the chemical composition contains the element group A.
(8) The surface-treated member according to (6), in which
the chemical composition contains the element group B.
(9) The surface-treated member according to (6), in which
the chemical composition contains the element group C.
(10) The surface-treated member according to (6), in which
the chemical composition contains the element group D.
(11) The surface-treated member according to (6), in which
the chemical composition contains the element group E.
(12) The surface-treated member according to (6), in which
the chemical composition contains the element group F.
(13) The surface-treated member according to any one of (6) to (12), in which

the zinc-based coatings layer is a coatings layer containing at least, in mass%,
Al: 4.0% or more and less than 25.0%, and
Mg: 0.3% or more and less than 12.5%.

(14) The surface-treated member according to any one of (1) to (13), in which
when the upper limit of measured values of the steel base exposure ratio obtained is denoted as A [%] and the coating weight per side of the zinc-based coatings layer is denoted as B [g/m$^2$], Formula (1) and Formula (2) below are both satisfied.

$$A \leq 0.8 \times 10^{-1} \times B + 28.0 \ \text{... Formula (1)}$$

$$A \leq 40.0 \ \text{... Formula (2)}$$

(15) The surface-treated member according to any one of (1) to (14), in which

the coating weight of the zinc-based coatings layer is 50.0 to 150.0 g/m$^2$ per side.

(16) The surface-treated member according to any one of (1) to (15), in which
at least one or more cross sections each having the steel base exposure ratio falling within a range of 5.0 to 40.0% are present.

EXPLANATION OF CODES

1        surface-treated member
10       steel material
20       zinc-based coatings layer
201      steel base exposed portion

**Claims**

1. A surface-treated member being a surface-treated member formed of a surface-treated steel material including:

   a steel material serving as a base material; and
   zinc-based coatings layers located on surfaces of the steel material, wherein
   a steel base exposed portion, which is a portion where the surface of the steel material is exposed, is present in at least a portion of the zinc-based coatings layer,
   in a case where a cross section obtained by cutting the steel base exposed portion in the thickness direction of the steel material according to the shape of the steel base exposed portion when the zinc-based coatings layer is viewed in plan from above is observed with a microscope, at least one or more cross sections each having a steel base exposure ratio, which is a ratio of a portion where the surface of the steel material is exposed in the cross section, falling within a range of 1.0 to 40.0% are present,
   in the cross section having the steel base exposure ratio falling within a range of 1.0 to 40.0%, the shortest distance from any point on the surface of the exposed steel material to the zinc-based coatings layer is greater than 0 μm and 50.0 μm or less, and
   for each of regions where a cross section having the steel base exposure ratio being greater than 40.0% is given, the total area of the regions when viewed in plan from above is 5.0% or less relative to the entire area of the steel base exposed portion.

2. The surface-treated member according to claim 1, used by burying at least a portion of the steel base exposed portion in soil.

3. The surface-treated member according to claim 2, wherein

   the steel base exposed portion is specified by performing a color identification test, which causes a color reaction at a portion where a steel base is exposed, over the entire surface of the zinc-based coatings layer,
   in a case where each of the specified steel base exposed portions is viewed in plan from above the zinc-based coatings layer, each of the steel base exposed portions is virtually divided into rectangular regions each having a short side of 5 mm or more and an area of 1 cm$^2$ as a division, and for each of the divisions where the area ratio of the steel base exposed portion to the rectangular region is 3% or more, the cross section of each of the divisions is observed, and thereby the steel base exposure ratio is measured, and
   the ratio of the total area of the divisions where the cross section having the steel base exposure ratio falling within a range of 1.0 to 40.0% is obtained to the area of a portion buried in the soil is 5.0% or more.

4. The surface-treated member according to any one of claims 1 to 3, wherein

   the zinc-based coatings layer is a coatings layer having a chemical composition containing, in mass%,
   Al: 0.10% or more and less than 40.00%, and
   Mg: 0.10% or more and less than 15.00%, with the balance consisting of Zn and impurities.

5. The surface-treated member according to claim 4, wherein

   the zinc-based coatings layer is a coatings layer containing, in mass%,

Al: 0.10% or more and less than 40.00%,
Mg: 0.10% or more and less than 15.00%, and
Zn: 60.00% or more.

6. The surface-treated member according to any one of claims 1 to 3, wherein

the zinc-based coatings layer is a coatings layer having a chemical composition containing, in mass%,
Al: 0.10% or more and less than 40.00%,
Mg: 0.10% or more and less than 15.00%, and
further containing one or two or more selected from the group consisting of an element group A, an element group B, an element group C, an element group D, an element group E, and an element group F described below, with the balance consisting of Zn and impurities.
[Element group A]: one or two selected from the group consisting of Si: 2.50% or less and Fe: 5.00% or less
[Element group B]: one or two or more selected from the group consisting of Sb: less than 0.50%, Pb: less than 0.50%, and Sr: less than 0.50%
[Element group C]: one or two or more selected from the group consisting of Cu: less than 0.25%, Ti: less than 0.25%, Cr: less than 0.25%, Nb: less than 0.25%, Ni: less than 0.25%, Mn: less than 0.25%, Co: less than 0.25%, and V: less than 0.25%
[Element group D]: one or two or more selected from the group consisting of Sn: 20.00% or less, Bi: less than 5.00%, and In: less than 2.00%
[Element group E]: one or two or more selected from the group consisting of Ca: 3.00% or less, La: less than 0.50%, Ce: less than 0.50%, and Y: 0.50% or less
[Element group F]: B: less than 0.50%

7. The surface-treated member according to claim 6, wherein
the chemical composition contains the element group A.

8. The surface-treated member according to claim 6, wherein
the chemical composition contains the element group B.

9. The surface-treated member according to claim 6, wherein
the chemical composition contains the element group C.

10. The surface-treated member according to claim 6, wherein
the chemical composition contains the element group D.

11. The surface-treated member according to claim 6, wherein
the chemical composition contains the element group E.

12. The surface-treated member according to claim 6, wherein
the chemical composition contains the element group F.

13. The surface-treated member according to claim 6, wherein

the zinc-based coatings layer is a coatings layer containing at least, in mass%,
Al: 4.0% or more and less than 25.0%, and
Mg: 0.3% or more and less than 12.5%.

14. The surface-treated member according to any one of claims 1 to 3, wherein
when the upper limit of measured values of the steel base exposure ratio obtained is denoted as A [%] and the coating weight per side of the zinc-based coatings layer is denoted as B [g/m$^2$], Formula (1) and Formula (2) below are both satisfied.

$$A \leq 0.8 \times 10^{-1} \times B + 28.0 \ ... \ \text{Formula (1)}$$

$$A \leq 40.0 \ ... \ \text{Formula (2)}$$

15. The surface-treated member according to any one of claims 1 to 3, wherein
    the coating weight of the zinc-based coatings layer is 50.0 to 150.0 g/m² per side.

16. The surface-treated member according to claim 14, wherein
    the coating weight of the zinc-based coatings layer is 50.0 to 150.0 g/m² per side.

17. The surface-treated member according to any one of claims 1 to 3, wherein
    at least one or more cross sections each having the steel base exposure ratio falling within a range of 5.0 to 40.0% are
    present.

FIG. 1

STRUCTURE

PORTION IS
BURIED IN SOIL

SOIL

FIG. 2

FIG. 3

FIG. 4

FIG. 5

COLOR IDENTIFICATION TEST

DIVISION

$a > b \geqq 5 \text{ mm}$
$a \times b = 1 \text{ cm}^2$

CROSS-SECTION OBSERVATION

b

CROSS-SECTION
OBSERVATION
POSITION

a

$\Delta$
$\Delta$
$\Delta$

201

FIG. 6

OBSERVATION
VISUAL FIELD

L0

100 μm

100 μm

L1

L2

L3

A

Ls

20

10

FIG. 7

ONES HAVING DIRECTIONAL
PROPERTIES IN SHAPE OR
DISTRIBUTION

CUTTING LINE
DIRECTION

201

201

201

DIRECTIONAL
ORIENTATION

CUTTING LINE
DIRECTION

201

201

201

ONES HAVING ISOTROPIC SHAPE

ONES HAVING NO DIRECTIONAL PROPERTIES
IN SHAPE OR DISTRIBUTION

57

FIG. 8

COLOR IDENTIFICATION TEST

DIVISION

$a > b \geqq 5\ mm$
$a \times b = 1\ cm^2$

EDX ANALYSIS

STEEL BASE EXPOSED REGION

SHAPE OBTAINED BY CONNECTING POSITIONS 100 μm OUTWARD FROM OUTERMOST PERIPHERY

SHAPE OBTAINED BY CONNECTING OUTERMOST PERIPHERIES

**EP 4 772 673 A1**

## INTERNATIONAL SEARCH REPORT

International application No.

**PCT/JP2024/029297**

| A. | CLASSIFICATION OF SUBJECT MATTER |
|---|---|

*C23F 13/10*(2006.01)i; *C22C 18/04*(2006.01)i; *C23C 2/06*(2006.01)i; *C23F 13/02*(2006.01)i; *C23C 2/26*(2006.01)n
FI:   C23F13/10 A; C22C18/04; C23C2/06; C23F13/02 M; C23C2/26

According to International Patent Classification (IPC) or to both national classification and IPC

| B. | FIELDS SEARCHED |
|---|---|

Minimum documentation searched (classification system followed by classification symbols)

C23F13/10; C22C18/04; C23C2/06; C23F13/02; C23C2/26

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

| C. | DOCUMENTS CONSIDERED TO BE RELEVANT |
|---|---|

| Category* | Citation of document, with indication, where appropriate, of the relevant passages | Relevant to claim No. |
|---|---|---|
| X | JP 2014-231070 A (NISSHIN STEEL CO., LTD.) 11 December 2014 (2014-12-11) paragraphs [0001]-[0017], fig. 2 | 1-5, 14-17 |
| Y | | 1-17 |
| Y | JP 11-158657 A (NIPPON STEEL CORPORATION) 15 June 1999 (1999-06-15) paragraphs [0001]-[0038] | 1-17 |
| Y | JP 2003-206698 A (NISSHIN STEEL CO., LTD.) 25 July 2003 (2003-07-25) paragraphs [0001]-[0021] | 1-17 |
| Y | WO 2021/250973 A1 (NIPPON STEEL CORPORATION) 16 December 2021 (2021-12-16) paragraphs [0001]-[0077] | 1-17 |

☐ Further documents are listed in the continuation of Box C.        ☑ See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **08 October 2024** | **22 October 2024** |

| Name and mailing address of the ISA/JP | Authorized officer |
|---|---|
| **Japan Patent Office (ISA/JP)** 3-4-3 Kasumigaseki, Chiyoda-ku, Tokyo 100-8915 **Japan** | |
| | Telephone No. |

Form PCT/ISA/210 (second sheet) (July 2022)

**INTERNATIONAL SEARCH REPORT**
Information on patent family members

International application No.

**PCT/JP2024/029297**

| Patent document cited in search report | | | Publication date (day/month/year) | Patent family member(s) | | Publication date (day/month/year) |
|---|---|---|---|---|---|---|
| JP | 2014-231070 | A | 11 December 2014 | (Family: none) | | |
| JP | 11-158657 | A | 15 June 1999 | (Family: none) | | |
| JP | 2003-206698 | A | 25 July 2003 | (Family: none) | | |
| WO | 2021/250973 | A1 | 16 December 2021 | US 2023/0235437 A1 pp. 1-9 EP 4163412 A1 KR 10-2023-0005364 A CN 115698366 A | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H11158657 A

**Non-patent literature cited in the description**

- **SHOZO MATSUDA** ; **TADASHI TANAKA** ; **KEIICHI TANIKAWA**. New Pinhole Test Method for Galvanized Sheet Steel. *Metal Surface Technology*, 1972, vol. 23, 142-146